# EUROPEAN PATENT APPLICATION

(11) **EP 4 718 997 A1**
(43) Date of publication of application: **01.04.2026**
(21) Application number: 24840153.1
(22) Date of filing: 30.05.2024
(51) Int. Cl.: H10F 10/00

(54) **FRAME-INTEGRATED PHOTOVOLTAIC MODULE HAVING G-TO-S STRUCTURE, BIPV SYSTEM USING SAME, AND METHOD FOR MANUFACTURING FRAME-INTEGRATED PHOTOVOLTAIC MODULE HAVING G-TO-S STRUCTURE**

(30) Priority: 11.07.2023 KR 20230090036
(71) Applicant: Eppscore Co., LTD., Naju-si, Jeollanam-do 58275 (KR)
(72) Inventor: PARK, Sung-cheul, Seoul 01713 (KR)
(74) Representative: V.O.
(86) International application number: PCT/KR2024/095857
(87) International publication number: WO 2025/014343

(57) **Abstract**

The present invention relates to: a frame-integrated photovoltaic module having a G-to-S structure, wherein the module replaces a conventional photovoltaic module having a G-to-G structure or a G-to-B structure and does not require a process of coupling a photovoltaic module and a frame; a BIPV system using same; and a method for manufacturing a frame-integrated photovoltaic module having a G-to-S structure, whereby a photovoltaic module having a G-to-S structure in which the photovoltaic module and the frame are integrated can be manufactured through a single laminating process. The frame-integrated photovoltaic module having a G-to-S structure comprises: a planar frame providing a mounting space for an encapsulant, a photovoltaic cell, and a front light-transmitting glass, and serving as a mechanical medium which enables the module to be mounted to a specific structure; an encapsulant in which the photovoltaic cell provided on the planar frame is encapsulated; and front light-transmitting glass provided on the encapsulant in which the photovoltaic cell is encapsulated.

## Description

### [Technical Field]

The present disclosure relates to a frame-integrated photovoltaic module having a G-to-S structure, a BIPV system using the same, and a method for manufacturing the frame-integrated photovoltaic module having the G-to-S structure. More specifically, the present disclosure relates to: a frame-integrated photovoltaic module having a G-to-S structure, which replaces conventional photovoltaic modules having a G-to-G structure or a G-to-B structure and does not require a process of coupling a photovoltaic module and a frame; a BIPV system using the module; and a method for manufacturing a frame-integrated photovoltaic module having a G-to-S structure, whereby a photovoltaic module having a G-to-S structure in which the photovoltaic module and the frame are integrated can be manufactured through a single laminating process.

### [Background Art]

In general, a photovoltaic module has a G-to-G (glass to glass) structure or a G-to-B (glass to back sheet) structure. The G-to-G structure is a structure in which a photovoltaic cell surrounded by an encapsulant is provided between two pieces of glass, and the G-to-B structure is a structure in which a photovoltaic cell surrounded by an encapsulant is provided between glass and a back sheet. That is, the G-to-G structure is a structure in which a rear encapsulant, a photovoltaic cell, a front encapsulant, and a front glass are sequentially stacked on a rear glass, and the G-to-B structure is a structure in which a rear encapsulant, a photovoltaic cell, a front encapsulant, and a front glass are sequentially stacked on a back sheet.

Photovoltaic modules having such a G-to-G structure or a G-to-B structure are coupled with a frame and installed on various land-based or water-based structures.

Recently, a building-integrated photovoltaic (BIPV) system is attracting attention. Whereas existing photovoltaic modules are mounted on separate structures and used for power generation, the BIPV system has an advantage in that a photovoltaic module is applied as an exterior material of a building and functions not only for photovoltaic power generation but also as a building material.

Photovoltaic modules applied to BIPV systems are also implemented using photovoltaic modules having a G-to-G structure or a G-to-B structure like existing photovoltaic modules, and frame-integrated photovoltaic modules for coupling with building exterior walls, etc. are applied as photovoltaic modules for BIPV systems.

The frames that are applied to photovoltaic modules for BIPV systems mostly have a rectangular frame shape of a picture-frame form, while there are some differences. That is, a rectangular frame is coupled to surround the edge of photovoltaic modules, or a rectangular frame is coupled on the edge of photovoltaic modules (see Patent Literatures 1 to 3).

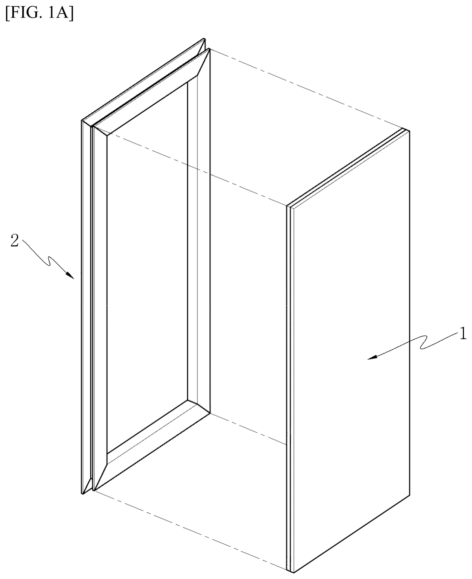

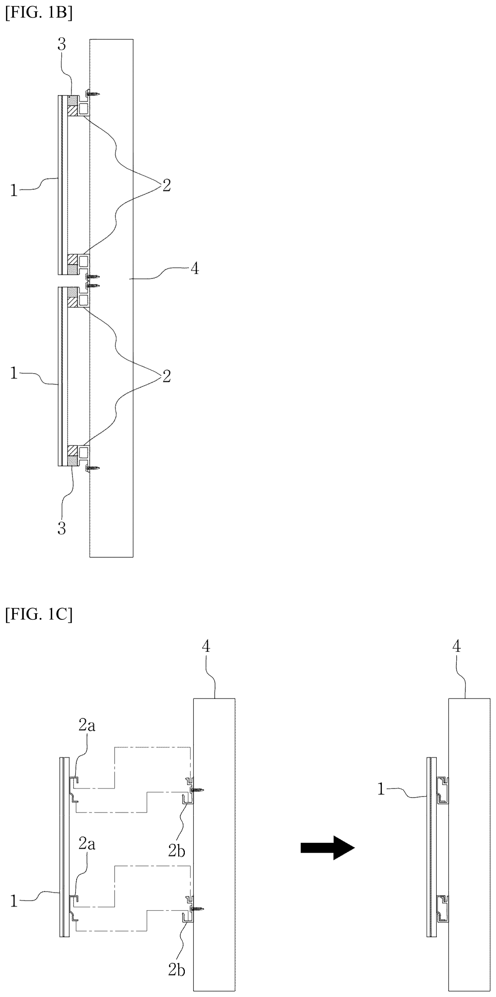

In most cases, a rectangular frame 2 having a picture-frame shape as shown in FIG. 1A is applied not only to photovoltaic modules for BIPV systems but also to the photovoltaic module 1 that is applied to other applications. Further, as shown in FIG. 1B, the photovoltaic module 1 is fixed in such a manner that the picture-frame-shaped rectangular frame 2 is secured to the structure 4 through bolting. For reference, in addition to bolting, as shown in FIG. 1C, a method is also adopted in which hanging brackets 2a and 2b are provided respectively on the photovoltaic module 1 and the structure 4, and the photovoltaic module 1 is fixed in a hanger-type rather than a bolt type.

As described above, in order for a photovoltaic module to be used for BIPV systems or mounted to a specific structure, coupling with a frame is required, and accordingly, a process of coupling the photovoltaic module and the frame is applied after the manufacturing of the photovoltaic module. That is, after a photovoltaic module having a G-to-G or G-to-B structure is manufactured through laminating, a process of coupling a frame to the photovoltaic module is required. An adhesive such as silicone is generally used for the coupling of the photovoltaic module and the frame (reference numeral 3 in FIG. 1B).

As described above, in the prior art, since a process of coupling a photovoltaic module and a frame has to be additionally performed in addition to the laminating process for manufacturing the photovoltaic module, there is a problem that the manufacturing process is complicated and the manufacturing cost increases. Further, photovoltaic modules having a G-to-G structure or a G-to-B structure of the prior art have a problem that heat is accumulated inside the photovoltaic modules in a high-temperature environment, so the photoelectric conversion efficiency is reduced.

### [Citation List]

### [Patent Literature]

[Patent Literature 1]
   Korean Patent Application Publication No. 2023-53018 (published on Apr. 21, 2023)
[Patent Literature 2]
   Korean Patent Application Publication No. 2023-78291 (published on Jun. 2, 2023)
[Patent Literature 3]
   Korean Patent No. 2501044 (issued on Feb. 17, 2023)
[Patent Literature 4]
   Japanese Patent No. 5927560 (issued on Jun. 1, 2016)
[Patent Literature 5]
   Japanese Patent No. 5608171 (issued on Oct. 15, 2014)
[Patent Literature 6]
   Japanese Patent Application Publication No. 2021-93469 (published on Jun. 17, 2021)

### [Non Patent Literature]

[N on Patent Literature 1]
   G Oreski et al., Properties and degradation behaviour of polyolefin encapsulants for photovoltaic modules. Prog Photovolt Res Appl. 2020;28:1277-1288
[Non-Patent Literature 2]
   Gernot M. Wallner et al., Comparison of Crosslinking Kinetics of UV-Transparent Ethylene-Vinyl Acetate Copolymer and Polyolefin Elastomer Encapsulants. Polymers (Basel). 2022 Apr; 14(7): 1441
[Non-Patent Literature 3]
   Bae, S.-H. et al., "Evaluation of Heat Dissipation Characteristics of Photovoltaic Modules According to Back Sheet Types," Current Photovoltaic Research, 6(2) 39-42 (2018)

### [Summary of Invention]

### [Technical Problem]

The present disclosure has been devised to solve the above-described problems, and an objective thereof is to provide a frame-integrated photovoltaic module having a G-to-S structure that does not require a process of coupling a photovoltaic module and a frame by replacing photovoltaic modules having a G-to-G structure or a G-to-B structure in the prior art, and a BIPV system using the frame-integrated photovoltaic module.

Further, another object is to provide a frame-integrated photovoltaic module having a G-to-S structure that can minimize a decrease in photoelectric conversion efficiency in a high-temperature environment through excellent heat dissipation characteristics, and a BIPV system using the frame-integrated photovoltaic module.

Furthermore, another objective of the present disclosure is to provide a method for manufacturing a frame-integrated photovoltaic module having a G-to-S structure that can manufacture a photovoltaic module having a G-to-S structure in which a photovoltaic module and a frame are integrated through a single laminating process.

### [Solution to Problem]

In order to achieve the objectives described above, a frame-integrated photovoltaic module having a G-to-S structure according to the present disclosure includes: a planar frame that provides a mounting space for an encapsulant, a photovoltaic cell, and a front light-transmitting glass and that serves as a mechanical medium enabling mounting to a specific structure; an encapsulant in which the photovoltaic cell provided on the planar frame is encapsulated; and the front light-transmitting glass provided on the encapsulant in which the photovoltaic cell is encapsulated, wherein a structure in which the encapsulant, in which the photovoltaic cell is encapsulated, and the front light-transmitting glass are sequentially stacked on the planar frame is formed through a single laminating process.

The planar frame is made of a metal material having excellent thermal conductivity, thereby performing a role of a heat dissipation plate that dissipates heat in the photovoltaic module to the outside.

The planar frame includes: a plate portion that provides a mounting space for the encapsulant, the photovoltaic cell, and the front light-transmitting glass; and a module fixing portion provided on at least one edge of the plate portion and performing a role of the mechanical medium enabling mounting to a specific structure.

The module fixing portion includes a vertical member and a horizontal member, and the vertical member is provided on at least one edge of the plate portion to be perpendicular to the plate portion, and the horizontal member is provided to be perpendicular to an end of the vertical member and disposed toward the outside of the plate portion.

The planar frame includes: a plate portion that provides a mounting space for the encapsulant, the photovoltaic cell, and the front light-transmitting glass; and a module fixing portion provided on both sides of the plate portion and performing a role of the mechanical medium enabling mounting to a specific structure, the module fixing portion includes a vertical member and a horizontal member, and the vertical member is provided on both sides of the plate portion to be perpendicular to the plate portion, and the horizontal member is provided to be perpendicular to an end of the vertical member and disposed toward the inside of the plate portion.

The horizontal member has a bracket mounting groove formed by boring the horizontal member by a predetermined area, and when the photovoltaic module is mounted on a specific structure, the bracket mounting groove is coupled in a hanger-type to a module fixing bracket fixed to the structure.

The planar frame includes a plate portion providing a mounting space for an encapsulant, a photovoltaic cell, and a front light-transmitting glass, and an upper module fixing portion and a lower module fixing portion respectively provided on an upper edge and a lower edge of the plate portion; the upper module fixing portion includes a vertical member provided on the upper edge of the plate portion to be perpendicular to the plate portion and a horizontal member provided to be perpendicular to an end of the vertical member and disposed toward the inside of the plate portion; and the lower module fixing portion includes a vertical member provided on the lower edge of the plate portion to be perpendicular to the plate portion and a horizontal member provided to be perpendicular to an end of the vertical member and disposed toward the outside of the plate portion.

When the photovoltaic module is mounted on a specific structure, the horizontal member of the upper module fixing portion and the horizontal member of the lower module fixing portion are coupled in a hanger-type to module fixing brackets fixed to the structure.

An internal space is defined on a rear side of the planar frame by the plate portion and the vertical member, and a junction box and wirings are accommodated in the internal space of the planar frame.

The encapsulant is made of polyolefin elastomer (POE) or ethylene vinyl acetate copolymer (EVA).

An insulating steel plate is used as the planar frame or insulating coating is applied to the planar frame for electrical insulation from the photovoltaic cell.

An insulating film having electrical insulation may be provided between the planar frame and the photovoltaic cell.

A BIPV system using a frame-integrated photovoltaic module having a G-to-S structure according to the present disclosure, includes: a frame-integrated photovoltaic module having a G-to-S structure; and a structure providing a mounting space for the frame-integrated photovoltaic module having a G-to-S structure, wherein the structure has a configuration in which a plurality of vertical bars and horizontal bars are arranged in a lattice pattern and a rectangular unit mounting space is defined by the plurality of vertical bars and horizontal bars; the frame-integrated photovoltaic module having a G-to-S structure is the frame-integrated photovoltaic module having a G-to-S structure of claim 4; and bolts are fastened to the vertical bar or the horizontal bar through the horizontal member with the horizontal member of the planar frame supported on surfaces of the vertical bars and horizontal bars around the unit mounting space.

Further, a BIPV system using a frame-integrated photovoltaic module having a G-to-S structure according to the present disclosure, includes: a frame-integrated photovoltaic module having a G-to-S structure; a structure providing a mounting space for the frame-integrated photovoltaic module having a G-to-S structure; and a module fixing bracket provided on one surface of the structure, wherein the frame-integrated photovoltaic module having a G-to-S structure is the frame-integrated photovoltaic module having a G-to-S structure of claim 6; the module fixing bracket is divided into a first bracket and a second bracket, and a recessed seat is provided between the first bracket and the second bracket; and the first bracket of the module fixing bracket is inserted in a bracket mounting groove, and the horizontal member above the bracket mounting groove is fitted in the seat between the first bracket and the second bracket.

Two module fixing brackets are provided as a pair and spaced apart from each other, and two adjacent frame-integrated photovoltaic modules having a G-to-S structure are fixed to the module fixing brackets, respectively.

Further, a BIPV system using a frame-integrated photovoltaic module having a G-to-S structure according to the present disclosure, includes: a frame-integrated photovoltaic module having a G-to-S structure; a structure providing a mounting space for the frame-integrated photovoltaic module having a G-to-S structure; and a plurality of module fixing brackets spaced apart and repeatedly arranged on one surface of the structure along a vertical direction of the structure, wherein the frame-integrated photovoltaic module having a G-to-S structure is the frame-integrated photovoltaic module having a G-to-S structure of claim 7; the module fixing brackets include a first seat that provides a space in which the horizontal member of the upper module fixing portion is seated and a second seat that provides a space in which the horizontal member of the lower module fixing portion is seated; and when a first module fixing bracket and a second module fixing bracket are provided on the structure, the horizontal member of the upper module fixing portion is seated in the first seat of the first module fixing bracket, and the horizontal member of the lower module fixing portion is seated in the second seat of the second module fixing bracket.

A method for manufacturing a frame-integrated photovoltaic module having a G-to-S structure according to the present disclosure includes: seating a laminate object on a heating plate of a laminating apparatus; disposing a bubble discharge guide member at a side of the laminate object and disposing a height compensation member in an interior space of a planar frame positioned at an uppermost position of the laminate object; and performing laminating by pressing the laminate object using a pressing pad, wherein the laminate object is a structure including a photovoltaic cell and an encapsulant between a front light-transmitting glass and the planar frame.

The laminate object is a structure in which an upper encapsulant, a photovoltaic cell, a lower encapsulant, and a planar frame are sequentially stacked on a front light-transmitting glass.

The laminate object is a structure in which an encapsulant, an insulating film, an encapsulant, a photovoltaic cell, an encapsulant, and a planar frame are sequentially stacked on a front light-transmitting glass.

The planar frame includes a plate portion providing a mounting space for an encapsulant, a photovoltaic cell, and a front light-transmitting glass, and a module fixing portion provided on each edge of the plate portion and serving as a mechanical medium enabling mounting to a specific structure; the module fixing portion includes a vertical member and a horizontal member, the vertical member is provided on each edge of the plate portion to be perpendicular to the plate portion, and the horizontal member is provided to be perpendicular to one end of the vertical member and disposed toward the outside of the plate portion; an internal space is defined on a rear side of the planar frame by the plate portion and the vertical member; and an upper surface height of the height compensation member is higher than an upper surface height of the horizontal member.

A bubble discharge guide member is divided into a first member and a second member; the first member of the bubble discharge guide member is disposed in contact with both the horizontal member and the vertical member of the module fixing portion, and the second member is disposed adjacent to the horizontal member of the module fixing portion; and a height of the first member corresponds to a height at which a lower surface of the horizontal member is positioned, and a height of the second member is higher than a height at which an upper surface of the horizontal member is positioned.

The planar frame includes a plate portion providing a mounting space for an encapsulant, a photovoltaic cell, and a front light-transmitting glass, and a module fixing portion provided on both sides of the plate portion and serving as a mechanical medium enabling mounting to a specific structure; the module fixing portion includes a vertical member and a horizontal member; the vertical member is provided on both sides of the plate portion to be perpendicular to the plate portion, and the horizontal member is provided to be perpendicular to one end of the vertical member and disposed toward the inside of the plate portion; an internal space is defined on a rear side of the planar frame by the plate portion and the vertical member; and an uppermost surface height of the height compensation member and an uppermost surface height of the bubble discharge guide member are higher than a height of the horizontal member.

The planar frame includes a plate portion providing a mounting space for an encapsulant, a photovoltaic cell, and a front light-transmitting glass, and an upper module fixing portion and a lower module fixing portion respectively provided on an upper edge and a lower edge of the plate portion; the upper module fixing portion includes a vertical member provided on the upper edge of the plate portion to be perpendicular to the plate portion, and a horizontal member provided to be perpendicular to an end of the vertical member and disposed toward the inside of the plate portion; the lower module fixing portion includes a vertical member provided on the lower edge of the plate portion to be perpendicular to the plate portion, and a horizontal member provided to be perpendicular to an end of the vertical member and disposed toward the outside of the plate portion; an internal space is defined on a rear side of the planar frame by the plate portion and the vertical member; and an uppermost surface height of the height compensation member and an uppermost surface height of the bubble discharge guide member are higher than a height of the horizontal member.

The bubble discharge guide member is made of a material that is higher in thermal conductivity than the front light-transmitting glass; and during laminating, bubbles in the encapsulant move from the front light-transmitting glass toward the bubble discharge guide member and are discharged to the outside of the encapsulant.

### [Advantageous Effects of Invention]

The frame-integrated photovoltaic module having a G-to-S structure according to the present disclosure, and the method for manufacturing the frame-integrated photovoltaic module, provide the following effects.

Since the frame-integrated photovoltaic module having a G-to-S structure is manufactured through a single laminating process, a process of coupling a photovoltaic module and a frame can be omitted, whereby it is possible to simplify the manufacturing process and significantly reduce manufacturing costs. In addition, because the planar frame, which is a component of the G-to-S structure, replaces the combination of a back sheet (or rear light-transmitting glass) and a frame in the prior art, it is possible to reduce material costs.

Furthermore, the planar frame performs the role of a heat dissipation plate, thereby dissipating heat in the photovoltaic module to the outside. Accordingly, it is possible to minimize a reduction of photoelectric conversion efficiency of photovoltaic modules in a high-temperature environment.

In addition, when POE is applied as the encapsulant in the frame-integrated photovoltaic module having a G-to-S structure, bubbles generated during laminating can be smoothly discharged, so it is possible to solve the problem of residual bubbles associated with the application of POE.

### [Brief Description of Drawings]

FIG. 1A to FIG. 1C are a configuration view of a photovoltaic module having a G-to-B structure or a G-to-G structure according to the prior art and reference views for illustrating manners in which the photovoltaic module is coupled to a structure.
FIG. 2 to FIG. 4 are configuration views of a frame-integrated photovoltaic module having a G-to-S structure according to a first embodiment of the present disclosure.
FIG. 5A and FIG. 5B are exploded perspective views of a frame-integrated photovoltaic module having a G-to-S structure according to a modified embodiment of the present disclosure.
FIG. 6 is a configuration view of a frame-integrated photovoltaic module having a G-to-S structure according to a second embodiment of the present disclosure.
FIG. 7 is a configuration view of a frame-integrated photovoltaic module having a G-to-S structure according to a third embodiment of the present disclosure.
FIG. 8 is a configuration view of a BIPV system to which the frame-integrated photovoltaic module having a G-to-S structure according to the first embodiment of the present disclosure is applied.
FIG. 9 is a configuration view of a BIPV system to which the frame-integrated photovoltaic module having a G-to-S structure according to the second embodiment of the present disclosure is applied.
FIG. 10 is a configuration view of a BIPV system to which the frame-integrated photovoltaic module having a G-to-S structure according to the third embodiment of the present disclosure is applied.
FIG. 11A to FIG. 11C are reference views for illustrating a method for manufacturing a frame-integrated photovoltaic module having a G-to-S structure according to a first embodiment of the present disclosure.
FIG. 12A is a reference view for illustrating a laminating process when a height-compensation member and a bubble discharge guide member are not applied.
FIG. 12B is a photograph of a photovoltaic module with bubbles remaining as a result of FIG. 12A.
FIG. 13A is a photograph of a planar frame that is actually manufactured, FIG. 13B is a photograph of a frame-integrated photovoltaic module having a G-to-S structure manufactured according to the first embodiment of the present disclosure, and FIG. 13C is a photograph of the rear surface of the frame-integrated photovoltaic module having a G-to-S structure shown in FIG. 13B.
FIG. 14A to FIG. 14C are reference views for illustrating a method for manufacturing a frame-integrated photovoltaic module having a G-to-S structure according to a second embodiment of the present disclosure.
FIG. 15A to FIG. 15C are reference views for illustrating a method for manufacturing a frame-integrated photovoltaic module having a G-to-S structure according to a third embodiment of the present disclosure.
FIG. 16 is a photograph of photovoltaic modules having G-to-S and G-to-G structures manufactured according to an experimental example.
FIG. 17 is a photograph of photovoltaic modules having G-to-S and G-to-G structures placed outdoors according to an experimental example.
FIG. 18 is a reference view for illustrating a temperature measurement method.
FIG. 19 is a reference view showing a temperature and a power generation capacity measured at an outdoor temperature of 33°C.
FIG. 20 is a reference view showing a temperature and a power generation capacity measured at an outdoor temperature of 29°C.

### [Description of Embodiments]

The present disclosure proposes a photovoltaic module with a new structure.

As described above in "Summary of the Invention", photovoltaic modules of the prior art have a G-to-G (glass-to-glass) or G-to-B (glass-to-back-sheet) structure. Further, a process of coupling the photovoltaic module and a frame is additionally required after manufacturing a photovoltaic module having a G-to-G or G-to-B structure through a laminating process. Here, the frame refers to a mechanical device for mounting the photovoltaic module on a building or a specific structure.

The present disclosure proposes a frame-integrated photovoltaic module having a G-to-S (glass-to-steel) structure. Further, the present disclosure proposes a technology capable of manufacturing a frame-integrated photovoltaic module having a G-to-S structure through a single laminating process. Furthermore, the present disclosure proposes a technology capable of minimizing residual bubbles in an encapsulant when manufacturing a frame-integrated photovoltaic module having a G-to-S structure through a laminating process.

A frame-integrated photovoltaic module having a G-to-S structure according to the present disclosure, which is manufactured through a single laminating process, has a structure in which a photovoltaic cell surrounded by an encapsulant and a front light-transmitting glass are sequentially stacked on a planar frame.

When the frame-integrated photovoltaic module having a G-to-S structure according to the present disclosure is compared with photovoltaic modules having a G-to-G or G-to-B structure, it can be said that a combination of a rear light-transmitting glass of the G-to-G structure (or a back sheet of the G-to-B structure) and a rectangular frame is replaced with a planar frame according to the present disclosure. For reference, in the case of a photovoltaic module having a G-to-G structure, a photovoltaic cell surrounded by an encapsulant and a front light-transmitting glass are sequentially stacked on the front surface of a rear light-transmitting glass, and a rectangular frame having a picture-frame shape is coupled along the edge of the rear light-transmitting glass on the rear surface of the rear light-transmitting glass. In a photovoltaic module having a G-to-B structure, compared with a photovoltaic module having a G-to-G structure, a rear light-transmitting glass is replaced with a back sheet, and the remaining components and structure form the same configuration as those of the photovoltaic module having a G-to-G structure.

In the frame-integrated photovoltaic module having a G-to-S structure according to the present disclosure, the planar frame performs three roles. The first role is to provide a space in which a photovoltaic cell surrounded by an encapsulant and a front light-transmitting glass are sequentially stacked. This can be regarded as a role performed by the rear light-transmitting glass of the G-to-G structure or the back sheet of the G-to-B structure. The second role is the role of a mechanical device for mounting the photovoltaic module on a building or a specific structure, and this corresponds to the role of the rectangular frame in the prior art. The third role is the role of a heat dissipation plate, and this is provided because the planar frame is made of a metal material having excellent thermal conductivity.

As described above, the planar frame of the present disclosure performs not only both the role that is performed by the rear light-transmitting glass of the G-to-G structure (or the back sheet of the G-to-B structure) and the role that is performed by the rectangular frame, but also an additional role of a heat dissipation plate.

The fact that the planar frame replaces both the roles of the rear light-transmitting glass (or the back sheet) and the rectangular frame means that the mechanical structure of the photovoltaic module is simplified and that the manufacturing process of the photovoltaic module is streamlined. Further, the fact that the planar frame performs the role of a heat dissipation plate is directly involved in improving the power generation efficiency of the photovoltaic module.

As described in Non-Patent Literature 3, silicon-based photovoltaic cells exhibit a phenomenon in which the voltage decreases by approximately 2.3 mV/°C as the temperature increases, and, in order to prevent a reduction in power generation efficiency due to an increase in the temperature of a photovoltaic module, a cooling system or the like is applied to one side of the photovoltaic module. Non-Patent Literature 3 describes that, in a photovoltaic module having a G-to-B structure, it is possible to reduce the phenomenon of reduction in power generation efficiency under a high-temperature environment by applying a back sheet having relatively excellent thermal conductivity (α). For reference, the two types of back sheets applied in the experimental examples of Non-Patent Literature 3 have thermal conductivity (α) characteristics of 0.02 and 1.0 W/mK, respectively.

In this manner, when a photovoltaic module is exposed to a high-temperature environment and heat accumulates inside the photovoltaic module, the power generation efficiency of the photovoltaic module decreases in proportion to the increase in temperature. To address this, it is possible to partially mitigate the phenomenon of reduction in power generation efficiency by applying a material having relatively excellent thermal conductivity (α). The planar frame, which is a component of the present disclosure, effectively dissipates heat inside the photovoltaic module on the basis of a significantly superior thermal conductivity (α) characteristic compared with a back sheet (or glass), thereby suppressing a decrease in power generation efficiency of the photovoltaic module under a high-temperature environment.

The thermal conductivity (α) of a back sheet is 0.02 to 1.0 and the thermal conductivity (α) of glass is 0.55 to 0.75, whereas the thermal conductivity (α) of iron is approximately 83.5, so the planar frame of the present disclosure, which is made of a metal material having excellent thermal conductivity such as a steel plate, has a thermal conductivity (α) characteristic more than about 100 times higher than those of the rear light-transmitting glass of the G-to-G structure and the back sheet of the G-to-B structure of the prior art. Accordingly, by effectively performing the role of a heat dissipation plate on the basis of this, it is possible to prevent a decrease in the power generation efficiency of a photovoltaic module even in a high-temperature environment. In addition, the planar frame according to the present disclosure includes a module fixing portion having a shape extending from a plate portion and bent, and the module fixing portion having this shape enhances the heat dissipation effect. This will be described in detail below.

The role of a heat dissipation plate of the planar frame according to the present disclosure and the suppression of a decrease in power generation efficiency resulting therefrom are supported by experimental examples to be described below.

Meanwhile, the structural features and effects compared to the G-to-G or G-to-B structure are additionally emphasized through the manufacturing method. As mentioned above, the G-to-G or G-to-B structure requires a process of coupling a photovoltaic module and a frame after the manufacture of the photovoltaic module, whereas according to the present disclosure, a frame-integrated photovoltaic module having a G-to-S structure is manufactured through a single laminating process.

That is, according to the present disclosure, a frame-integrated photovoltaic module having a G-to-S structure is manufactured by performing a laminating process with a lower encapsulant, a photovoltaic cell, an upper encapsulant, and a front light-transmitting glass sequentially stacked on a planar frame.

As described above, since it is possible to manufacture a frame-integrated photovoltaic module having a G-to-S structure through a single laminating process, it is possible to reduce the time, equipment, and labor required for the process of coupling a photovoltaic module and a frame.

In manufacturing a frame-integrated photovoltaic module having a G-to-S structure through a single laminating process, two factors must be essentially considered. One is the adhesion characteristics between the encapsulant and the planar frame, and the other is to minimize the residual bubbles in the encapsulant during the laminating process. Here, the adhesion characteristics between the encapsulant and the planar frame include adhesion strength, moisture ingress resistance, durability, and electrical insulation characteristics.

In the present disclosure, as the encapsulant, a polyolefin elastomer (hereinafter referred to as "POE") or an ethylene vinyl acetate copolymer (hereinafter referred to as "EVA") may be applied, and most preferably, POE is applied as the encapsulant.

POE is superior to EVA in adhesion strength, moisture ingress resistance, and electrical insulation characteristics, and, unlike EVA, does not generate acetic acid and therefore exhibits superior durability as well (see Non-Patent Literature 1). As shown in Table 1 below, the glass adhesion strength of POE is approximately 1.8 times superior to that of EVA, and the moisture ingress rate of POE is more than ten times superior. Since the moisture ingress rate characteristic is directly related to delamination of a photovoltaic module, a high moisture ingress rate characteristic must be secured to improve the durability of a photovoltaic module. Further, the volume resistivity of POE is more than 100 times greater than that of EVA, and thus POE exhibits superior electrical insulation characteristics, which is attributable to POE having lower polarity than EVA. In addition, EVA generates acetic acid in high-temperature and high-humidity environments, and the generated acetic acid serves as a factor that causes corrosion of ribbons, electrodes, etc. of photovoltaic cells. In contrast, POE does not generate acetic acid even in high-temperature and high-humidity environments.

**[Table 1]**

| | | |
|---|---|---|
| | EVA | POE |
| Vinyl acetate content (wt%) | 28±4 | |
| Volume resistivity (Ω·cm) | ≥ 1x10¹⁴ | ≥ 1x10¹⁶ |
| Glass adhesion strength (N/cm) | 154 | 272 |
| Moisture ingress rate (g/m²·day) | 34 | 3.3 |

As described above, although POE has superior overall characteristics compared to EVA, it has been applied only to a limited extent as an encapsulant for photovoltaic modules. Specifically, although POE is applied as an encapsulant of photovoltaic modules having a G-to-B structure (see Japanese Patent Application Publication No. 5927560 (Patent Literature 4)) or as an encapsulant of thin-film photovoltaic cells (see Japanese Patent Application Publication No. 5608171 (Patent Literature 5)), there is no example in which POE has been applied as an encapsulant in photovoltaic modules having a G-to-G structure. Japanese Patent Application Publication No. 2021-93469 (Patent Literature 6) describes that POE can be applied to various photovoltaic modules such as G-to-B and G-to-G, but it neither specifies the application to photovoltaic modules having a G-to-G structure nor presents any experimental examples thereof. The biggest reason why photovoltaic modules having a G-to-G structure in which POE is applied as an encapsulant have not been commercialized is that bubbles remain in the encapsulant after completion of the laminating process. That is, in photovoltaic modules having a G-to-G structure to which EVA is applied, bubbles are relatively easily discharged during laminating, whereas in photovoltaic modules having a G-to-G structure to which POE is applied, bubbles are not readily discharged during laminating. This is presumed to be attributable to differences in the rate of gelation and the crosslinking time of EVA and POE during laminating. The rate of gelation of EVA is about four times faster than that of POE, and the crosslinking time of POE is known to require about 1.6 times longer than that of EVA based on the 95% crosslinking level required during laminating of a photovoltaic module (see Non-Patent Literature 2).

Due to these characteristics, when POE is applied as an encapsulant, bubbles in the POE are relatively readily discharged during laminating in the G-to-B structure in which an elastic back sheet is applied because the back sheet is compressed by a certain thickness during laminating, whereas in the G-to-G structure in which two non-elastic glasses are applied, bubbles are not readily discharged during laminating.

The applicant has acquired, through years of research, a technology that enables bubbles to be readily discharged during laminating of photovoltaic modules having a G-to-G structure to which POE is applied. However, no patent application has been filed for this technology.

The applicant applied the acquired bubble discharge technology, which discharges bubbles during laminating of photovoltaic modules having a G-to-G structure, to the method for manufacturing a frame-integrated photovoltaic module having a G-to-S structure according to the present disclosure, thereby achieving a state in which no bubbles remain in an encapsulant. This is based on the fact that the front light-transmitting glass and the planar frame made of a metal material that are applied to the G-to-S structure are non-elastic materials, like the two glasses of the G-to-G structure.

Specifically, during laminating of a photovoltaic module having a G-to-S structure, when the laminating process is performed with a bubble discharge guide members arranged at respective sides of the photovoltaic module and a height compensation member provided in the internal space of the planar frame, uniform pressure is applied over the entire region of the photovoltaic module and bubble discharge is induced, whereby bubbles in POE are easily discharged. This will be described in detail through embodiments to be described below.

Hereinafter, with reference to the drawings, a frame-integrated photovoltaic module having a G to S structure according to an embodiment of the present disclosure, a BIPV system using the frame-integrated photovoltaic module, and a method for manufacturing the frame-integrated photovoltaic module having a G to S structure will be described in detail.

The present disclosure proposes a frame-integrated photovoltaic module having a G to S structure according to the first to third embodiments. The first to third embodiments are designed in consideration of various coupling methods between the photovoltaic module and a structure. The photovoltaic module is mounted on and fixed to a structure such as a building exterior wall, and the coupling method can be largely classified into a bolt coupling method and a hanger-type coupling method. The bolt coupling method is a method in which a frame of a photovoltaic module is fixed to a structure by means of bolts, and the hanger-type coupling method is a method in which a photovoltaic module is fixed to a structure in a mounted state by means of hanger brackets. The first embodiment is designed in consideration of the bolt coupling method, and the second and third embodiments are designed in consideration of the hanger-type coupling method.

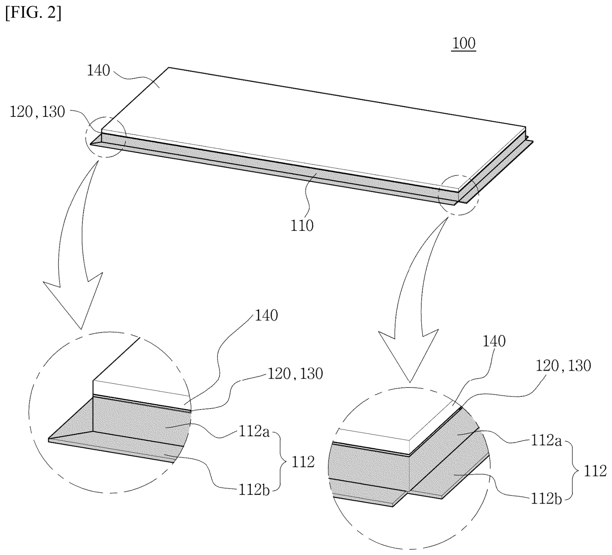

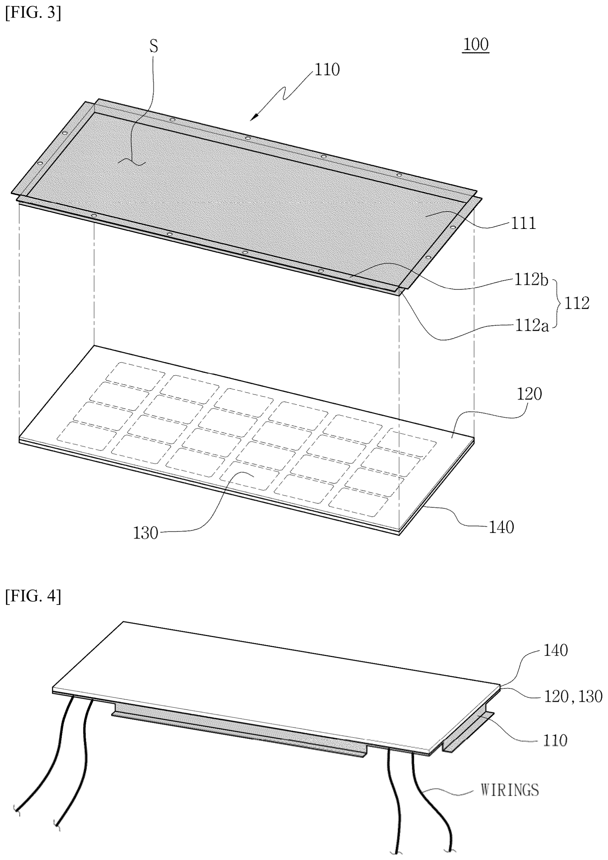

Referring to FIGS. 2 and 3, a frame-integrated photovoltaic module 100 having a G-to-S structure according to the first embodiment of the present disclosure has a structure in which an encapsulant 120 in which a photovoltaic cell 130 is encapsulated and a front light-transmitting glass 140 are sequentially stacked on a planar frame 110.

The planar frame 110 provides a mounting space for the encapsulant 120, the photovoltaic cell 130, and the front light-transmitting glass 140, and serves as a mechanical medium that enables the module to be mounted on a specific structure such as a building exterior wall.

The planar frame 110 is specifically divided into a plate portion 111 and a module fixing portion 112. The plate portion 111 and the module fixing portion 112 are both made of a metal material having excellent thermal conductivity and, in an embodiment, may be made of carbon steel such as SUS, or alloy steel. Hereinafter, for convenience of explanation, a description will be given mainly of a case where the planar frame is made of a "steel plate" material.

The plate portion 111 has a plate shape having a predetermined area and provides a mounting space for the encapsulant 120, the photovoltaic cell 130, and the front light-transmitting glass 140.

The module fixing portion 112 has a shape in which the steel plate is extended from at least one edge of the plate portion 111 and bent twice. In an embodiment, the steel plate is bent downward from each edge of the plate portion 111 to be perpendicular to the plate portion 111, and the downwardly bent steel plate is bent again at a certain point by 90 degrees outward of the plate portion 111 to be parallel to the plate portion 111.

Stated differently, the module fixing portion 112 may be regarded as a combination of a vertical member 112a and a horizontal member 112b, in which the vertical member 112a is provided on each edge of the plate portion 111 to be perpendicular to the plate portion 111, and the horizontal member 112b is disposed perpendicular to one end of the vertical member 112a and extends outward of the plate portion 111. In cross-section, the module fixing portion 112 has an " 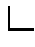 " shape or an " 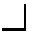 " shape, and such an " 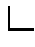 " or " 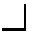 " shape extends along the longitudinal direction of the plate portion 111 on at least one edge of the plate portion 111. Here, the corners of the module fixing portion 112 may be machined with a cut-out portion as shown in the enlarged right-side view of FIG. 2, or may be machined with the adjacent horizontal members 112b in contact with each other as shown in the enlarged left-side view of FIG. 2.

The horizontal member 112b of the module fixing portion 112 is disposed in parallel with the plate portion 111, so when the photovoltaic module is installed, the horizontal member 112b of the module fixing portion 112 comes into contact with the structure on which the module is to be installed, and the photovoltaic module can be fixed to the structure by bolts or the like that penetrate through the horizontal member 112b and the structure. This method corresponds to the bolt coupling method as mentioned above. Details regarding the coupling between the horizontal member 112b and a structure will be described in detail in a later description of a BIPV system.

Meanwhile, since the module fixing portion 112 is provided in the form in which the steel plate extends from at least one edge of the plate portion 111 and is bent twice, a space (S in FIG. 3) defined by the plate portion 111 and the module fixing portion 112 is formed on the rear side of the plate portion 111, and a junction box, wirings, and the like are accommodated in the space. Accordingly, as a certain space is provided by the inherent shape of the planar frame 110 having the module fixing portion 112 and the junction box and the like can be accommodated in the space, there is no need to provide a separate device or space for accommodating the junction box.

The module fixing portion 112 is provided along the longitudinal direction of the plate portion 111 on at least one edge of the plate portion 111, and the length of the module fixing portion 112 may be made equal to the length of the plate portion 111 or may be made shorter than the length of the plate portion 111. As shown in FIG. 4, when the length of the module fixing portion 112 is made shorter than the length of the plate portion 111, a space provided on the rear surface of the plate portion 111 is exposed to the outside at each corner of the plate portion 111, and wirings may be led outside through the exposed regions or the wirings may be accommodated in the space provided on the rear surface of the plate portion 111.

Further, since the photovoltaic cell 130 is provided on the planar frame 110 made of a steel plate material, electrical insulation must be imparted to the planar frame 110 for electrical insulation from the photovoltaic cell 130, and for this purpose, it is preferable to use an insulating steel plate as the planar frame 110 or to perform insulating coating on the planar frame 110. It is also possible to apply an insulating film having electrical insulation property on the planar frame 110 during laminating in order to impart electrical insulation property to the planar frame 110.

The planar frame 110 serves as a rear light-transmitting glass of the G-to-G structure or as a back sheet of the G-to-B structure in that it provides a mounting space for the encapsulant 120 in which the photovoltaic cell 130 is encapsulated and for the front light-transmitting glass 140, and it performs a role of a rectangular frame mounted to photovoltaic modules having a G-to-G or G-to-B structure in that it can be installed on a specific structure through the module fixing portion 112.

In addition, since the planar frame 110 is made of a steel plate material, the planar frame 110 performs a role of a heat dissipation plate, so that heat inside the photovoltaic module can be dissipated to the outside through the planar frame 110, and it is possible to suppress reduction in photoelectric conversion efficiency caused by heat being accumulated inside the photovoltaic module under a high-temperature environment. Further, since additional heat dissipation is carried out through the module fixing portion 112 having the shape bent twice at 90 degrees in addition to heat dissipation through the plate portion 111, the heat dissipation effect by the planar frame 110 can be maximized.

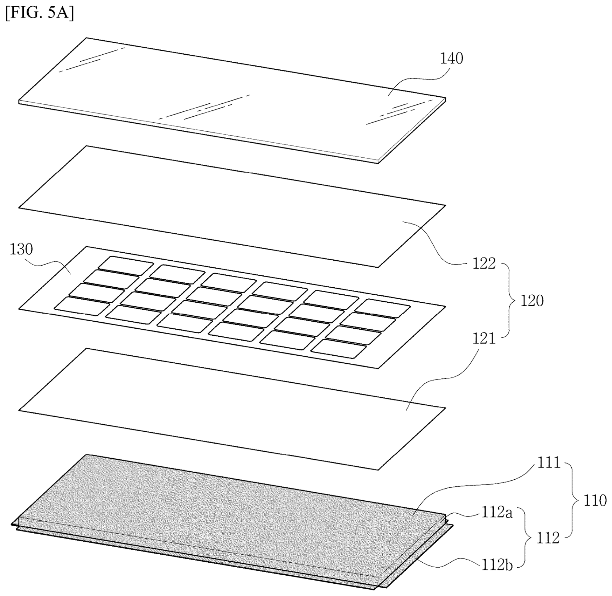

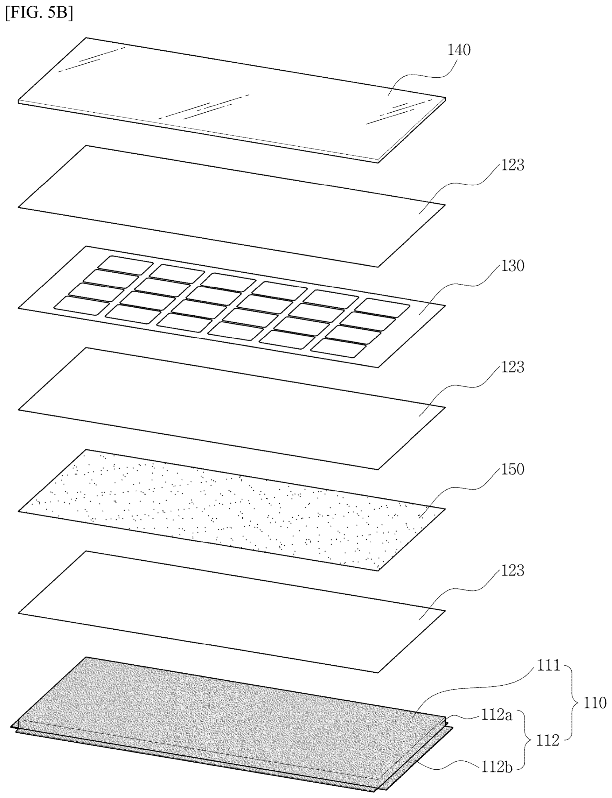

A structure in which the encapsulant 120 in which the photovoltaic cell 130 is encapsulated and the front light-transmitting glass 140 are sequentially stacked on the planar frame 110 is formed, and the encapsulant 120 in which the photovoltaic cell 130 is encapsulated means that, with the lower encapsulant 121, the photovoltaic cell 130, and the upper encapsulant 122 sequentially stacked on the planar frame 110 (see FIG. 5A), the lower encapsulant 121 and the upper encapsulant 122 are crosslinked by a laminating process, thereby forming one encapsulant 120 and the photovoltaic cell 130 is encapsulated in the encapsulant 120. The laminating process will be described in detail below. Here, as described above, the planar frame 110 must be imparted with electrical insulation property for electrical insulation from the photovoltaic cell 130, and when insulating coating is not applied to the planar frame 110, electrical insulation may also be imparted to the planar frame 110 using an insulating film. In this case, as shown in FIG. 5B, a laminating process may be performed with the encapsulant 123, the insulating film 150, the encapsulant 123, the photovoltaic cell 130, the encapsulant 123, and the front light-transmitting glass 140 sequentially stacked on the planar frame 110.

For the encapsulants 120 and 123, polyolefin elastomer (POE) or ethylene vinyl acetate copolymer (EVA) are used, and most preferably, POE is applied. EVA is a representative encapsulant for photovoltaic modules whose various characteristics have been verified, and POE is a material that has recently been attracting attention as an encapsulant for photovoltaic modules.

As described in Non-Patent Literature 1, POE has advantages of superior adhesion strength, moisture ingress resistance, and electrical insulation characteristics compared to EVA. The glass adhesion strength is about 1.8 times superior, the moisture ingress rate is more than 10 times superior, and the volume resistivity directly related to electrical insulation characteristics exhibits a characteristic more than 100 times greater.

Despite such comparative advantages, POE is applied only in a limited manner to the G-to-B structure in which a back sheet is applied or to thin-film photovoltaic cells, and in the G-to-G structure in which a back sheet is not applied, successful cases of applying POE have not been reported. The reason is that bubbles remain in POE after the laminating of a photovoltaic module having a G-to-G structure, and the reason why bubbles are not readily discharged during laminating is presumed to be due to the fact that the gelation rate of EVA is about four times faster than that of POE and the crosslinking time of POE requires about 1.6 times longer compared to EVA. That is, it is presumed that bubbles remain during the laminating of a photovoltaic module having a G-to-G structure due to such differences in physical properties between POE and EVA. However, in the G-to-B structure in which a back sheet is applied, bubbles are relatively readily discharged compared to the G-to-G structure because the back sheet has a certain level of elasticity.

The inventors of the present application acquired, through research, a technique for solving the problem of residual bubbles in photovoltaic modules having a G-to-G structure to which POE is applied, and by applying this technique, implemented easy discharge of bubbles during the laminating of the frame-integrated photovoltaic module having a G-to-S structure according to the present disclosure. The technical basis for applying the technique for solving the problem of residual bubbles in photovoltaic modules having a G-to-G structure to the G-to-S structure of the present disclosure originated from the fact that, like the G-to-G structure in which two glasses having no elasticity are applied, the front light-transmitting glass 140 and the planar frame 110 made of a steel plate material, both having no elasticity, are applied to the G-to-S structure as well. The laminating of the photovoltaic module having a G-to-S structure to which POE is applied will be described in detail below.

Next, the frame-integrated photovoltaic module having a G-to-S structure according to the second embodiment of the present disclosure is described. As mentioned above, in the second and third embodiments, the planar frame is designed in consideration of a hanger-type coupling method, and in the first embodiment described above, the planar frame is designed in consideration of a bolt fastening method.

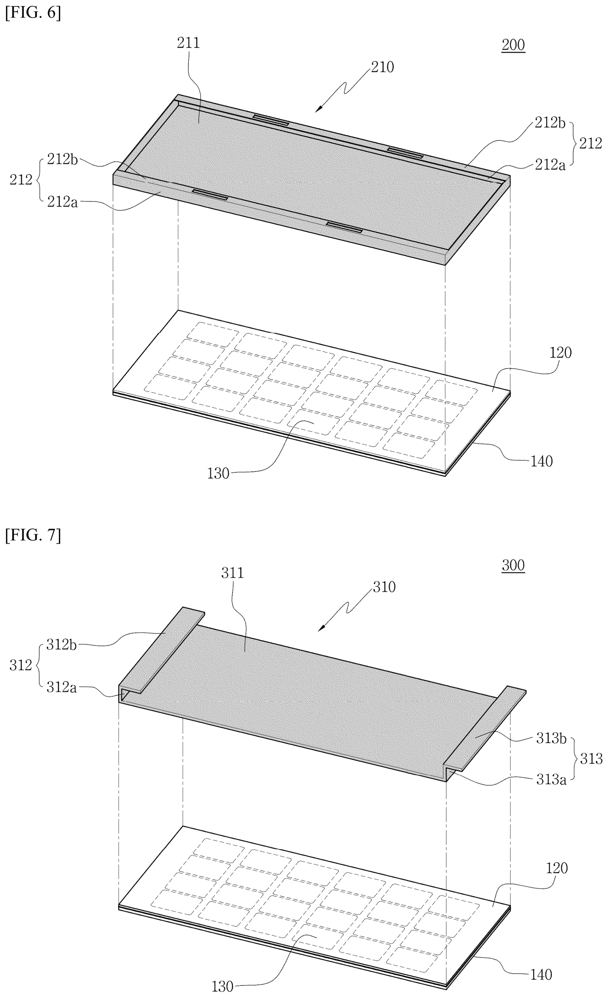

Referring to FIG. 6, a frame-integrated photovoltaic module 200 having a G-to-S structure according to the second embodiment of the present disclosure has a structure in which an encapsulant 120 in which a photovoltaic cell 130 is encapsulated and a front light-transmitting glass 140 are sequentially stacked on a planar frame 210. The planar frame 210 provides a mounting space for the encapsulant 120, the photovoltaic cell 130, and the front light-transmitting glass 140, and serves as a mechanical medium that enables the module to be mounted on a specific structure such as a building exterior wall. All components except the planar frame 210 are the same as those of the first embodiment, and in the third embodiment as well, all components except the planar frame 310 are the same as those of the first and second embodiments.

The planar frame 210 has a plate portion 211 and a module fixing portion 212, and is made of a steel plate material.

The plate portion 211 has a plate shape having a predetermined area and provides a mounting space for the encapsulant 120, the photovoltaic cell 130, and the front light-transmitting glass 140.

The module fixing portion 212 is provided on both sides of the plate portion 211, and has a form in which the steel plate is extended from each of the sides of the plate portion 211 and bent twice. Specifically, the steel plate is bent downward from each of both sides of the plate portion 211 to be perpendicular to the plate portion 211, and the downwardly bent steel plate is bent at a certain point by 90 degrees toward the inside of the plate portion 211 to be parallel to the plate portion 211.

The module fixing portion 212 may be regarded as a combination of a vertical member 212a and a horizontal member 212b, in which the vertical member 212a is provided on both sides of the plate portion 211 to be perpendicular to the plate portion 211, and the horizontal member 212b is disposed perpendicular to one end of the vertical member 212a. In this configuration, the horizontal member 212b is disposed toward the inside of the plate portion 211.

The horizontal member 212b has a bracket mounting groove 213 formed by boring the horizontal member 212b by a predetermined area. When the photovoltaic module of the present disclosure is mounted on a specific structure, the photovoltaic module is fixed to the structure in the form in which a module fixing bracket provided on the structure is inserted into the bracket mounting groove 213 of the horizontal member 212b. More precisely, the photovoltaic module is fixed to the structure in the manner in which the module fixing bracket is inserted into the bracket mounting groove 213 of the horizontal member 212b and a portion of the horizontal member 212b is seated on a seat provided on the module fixing bracket. This will be described in detail in a later description of a BIPV system.

In the case of the first embodiment, the photovoltaic module is fixed to the structure by bolting the horizontal member 112b of the planar frame to the structure, whereas in the second embodiment, the photovoltaic module is fixed to the structure by hanging the bracket mounting groove 213 of the horizontal member 212b onto the module fixing bracket. That is, as mentioned above, the planar frame of the first embodiment corresponds to a bolt coupling method, and the planar frame of the second embodiment corresponds to a hanger-type coupling method.

On the other hand, in the planar frame of the second embodiment, a member corresponding to the vertical member 112a of the module fixing portion 112 of the first embodiment may be selectively provided on the upper and lower edges of the plate portion 211. That is, on each of the upper and lower edges of the plate portion 211, a vertical member bent downward to be perpendicular to the plate portion 211 may be provided.

Next, the frame-integrated photovoltaic module having a G-to-S structure according to the third embodiment of the present disclosure is described with reference to FIG. 7. In the photovoltaic module of the third embodiment, all components except a planar frame 310 are the same as those of the photovoltaic modules of the first embodiment or the second embodiment.

The planar frame 310 is composed of a plate portion 311 and module fixing portions 312 and 313, and the module fixing portions are composed of an upper module fixing portion 312 and a lower module fixing portion 313. Further, as in the first and second embodiments, both the plate portion 311 and the module fixing portions 312 and 313 are made of a steel plate material.

The plate portion 311 has a plate shape having a predetermined area and provides a mounting space for the encapsulant 120, the photovoltaic cell 130, and the front light-transmitting glass 140.

The upper module fixing portion 312 has a form in which the steel plate extends from the upper edge of the plate portion 311, and the lower module fixing portion 313 has a form in which the steel plate extends from the lower edge of the plate portion 311. Both the upper module fixing portion 312 and the lower module fixing portion 313 have a shape of being bent twice, as in the module fixing portion 112 of the first embodiment.

In the case of the upper module fixing portion 312, the steel plate is bent downward from the upper edge of the plate portion 311 to be perpendicular to the plate portion 311, and the downwardly bent steel plate is bent at a certain point by 90 degrees toward the inside of the plate portion 311 to be parallel to the plate portion 311. The upper module fixing portion 312 may be regarded as a combination of a vertical member 312a and a horizontal member 312b, in which the vertical member 312a is provided on the upper edge of the plate portion 311 to be perpendicular to the plate portion 311, and the horizontal member 312b is disposed perpendicular to one end of the vertical member 312a. In this configuration, the horizontal member 312b is disposed toward the inside of the plate portion 311.

In the case of the lower module fixing portion 313, the steel plate is bent downward from the lower edge of the plate portion 311 to be perpendicular to the plate portion 311, and the downwardly bent steel plate is bent at a certain point by 90 degrees toward the outside of the plate portion 311 to be parallel to the plate portion 311. The lower module fixing portion 313 may be regarded as a combination of a vertical member 313a and a horizontal member 313b, in which the vertical member 313a is provided on the upper edge of the plate portion 311 to be perpendicular to the plate portion 311, and the horizontal member 313b is disposed perpendicular to one end of the vertical member 313a. In this configuration, the horizontal member 313a is disposed toward the outside of the plate portion 311. The shape of the lower module fixing portion 313 is the same as the shape of the module fixing portion 112 of the first embodiment.

As described above, the upper module fixing portion 312 and the lower module fixing portion 313 of the planar frame 310 according to the third embodiment are similar to the module fixing portion of the first embodiment in that each is a combination of the vertical members 312a and 313a and the horizontal members 312b and 313b, but are different in that the horizontal member 312b of the upper module fixing portion 312 of the second embodiment is disposed toward the inside of the plate portion 311.

In the third embodiment, the reason why the horizontal member 312b of the upper module fixing portion 312 is disposed toward the inside of the plate portion 311 and the horizontal member 313b of the lower module fixing portion 313 is disposed toward the outside of the plate portion 311 is for using the horizontal member 312b of the upper module fixing portion 312 and the horizontal member 313b of the lower module fixing portion 313 as hangers.

When the photovoltaic module is mounted on a building exterior wall in a vertically hung form, the horizontal member 312b of the upper module fixing portion 312 and the horizontal member 313b of the lower module fixing portion 313 are both disposed to face down. If brackets capable of receiving the horizontal member 312b of the upper module fixing portion 312 and the horizontal member 313b of the lower module fixing portion 313 are provided on a building exterior wall, the photovoltaic module can be fixed by inserting the horizontal member 312b of the upper module fixing portion 312 and the horizontal member 313b of the lower module fixing portion 313 into the brackets. This will be described in detail in a later description of a BIPV system.

On the other hand, in the planar frame 300 of the third embodiment, members corresponding to the vertical member 112a of the module fixing portion 112 of the first embodiment may be selectively provided on both sides of the plate portion. That is, vertical members bent downward to be perpendicular to the plate portion on both sides of the plate portion may be provided.

The frame-integrated photovoltaic modules having a G to S structure according to the first to third embodiments of the present disclosure were described above. Hereinafter, a BIPV system to which the frame-integrated photovoltaic module having a G-to-S structure of the present disclosure is applied is described. Since the frame-integrated photovoltaic module having a G-to-S structure of the present disclosure has the configuration of the first to third embodiments as described above, the BIPV system according to the present disclosure is also implemented in three types of embodiments.

The BIPV system according to the first embodiment is one to which the frame-integrated photovoltaic module 100 having a G-to-S structure according to the first embodiment is applied, the BIPV system according to the second embodiment is one to which the frame-integrated photovoltaic module 200 having a G-to-S structure according to the second embodiment is applied, and the BIPV system according to the third embodiment is one to which the frame-integrated photovoltaic module 300 having a G-to-S structure according to the third embodiment is applied. Further, in the BIPV system according to the first embodiment, the photovoltaic module is fixed to a structure by the bolt coupling method, and in the BIPV systems according to the second and third embodiments, the photovoltaic module is fixed to a structure by the hanger-type coupling method.

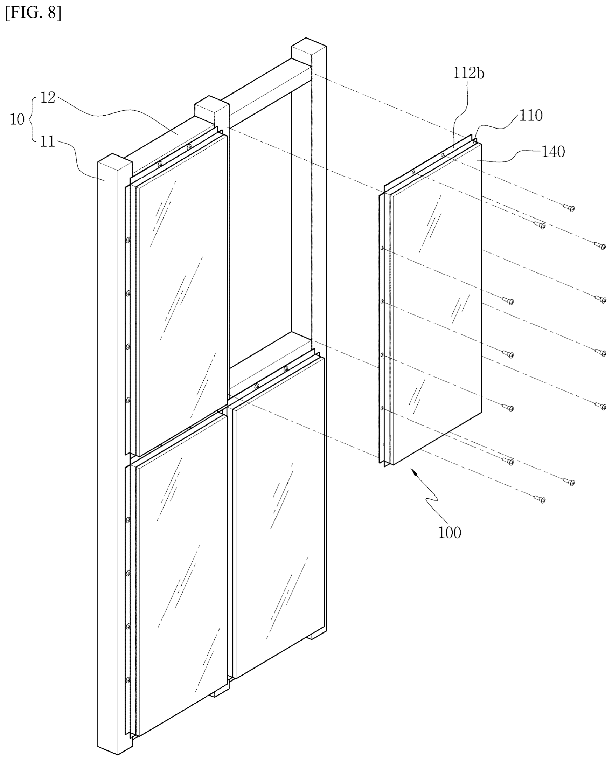

First, referring to FIG. 8, the BIPV system according to the first embodiment includes the frame-integrated photovoltaic module 100 having a G-to-S structure according to the first embodiment and a structure 10.

The structure 10 provides a space in which the photovoltaic module is fixed, and may be provided on one side of a building, for example, on an exterior wall or a roof of a building.

The structure 10 has a form in which a plurality of vertical bars 11 and horizontal bars 12 are arranged in a lattice pattern, and a plurality of rectangular spaces are provided by the plurality of vertical bars 11 and horizontal bars 12. Each rectangular space corresponds to a space in which the photovoltaic module 100 is mounted (hereinafter referred to as a unit mounting space).

The photovoltaic module 100 is mounted in the unit mounting space. Specifically, the photovoltaic module is mounted in the form in which the plate portion 111 of the planar frame 110 covers the unit mounting space, and the lower surface of the horizontal member 112b of the planar frame 111 is supported on the surfaces of the vertical bars 11 and horizontal bars 12 disposed around the unit mounting space, namely, those on the top, bottom, left, and right.

Bolts are fastened to the vertical bar 11 or the horizontal bar 12 through the horizontal member 112b with the horizontal member 112b of the planar frame 110 supported on the surfaces of the vertical bars 11 and horizontal bars 12 around the unit mounting space, whereby the photovoltaic module 100 is stably fixed to the structure 10.

When the BIPV system according to the first embodiment described above is compared with the prior art, in the prior art, as shown in FIG. 1B, a rectangular frame 2 is coupled to one side of the photovoltaic module 1 by means of an adhesive 3, and the photovoltaic module 1 is fixed through bolting between the rectangular frame 2 and a structure 4; however, in the present disclosure, because the planar frame 110 that is bolted to the structure 10 is one component of the photovoltaic module 100, a rectangular frame 2 is not required as in the prior art, and the process of coupling a frame to a photovoltaic module is not required, whereby it is possible to simplify the installation structure of a BIPV system and streamline the installation process of the BIPV system.

Next, the BIPV system according to the second embodiment is described.

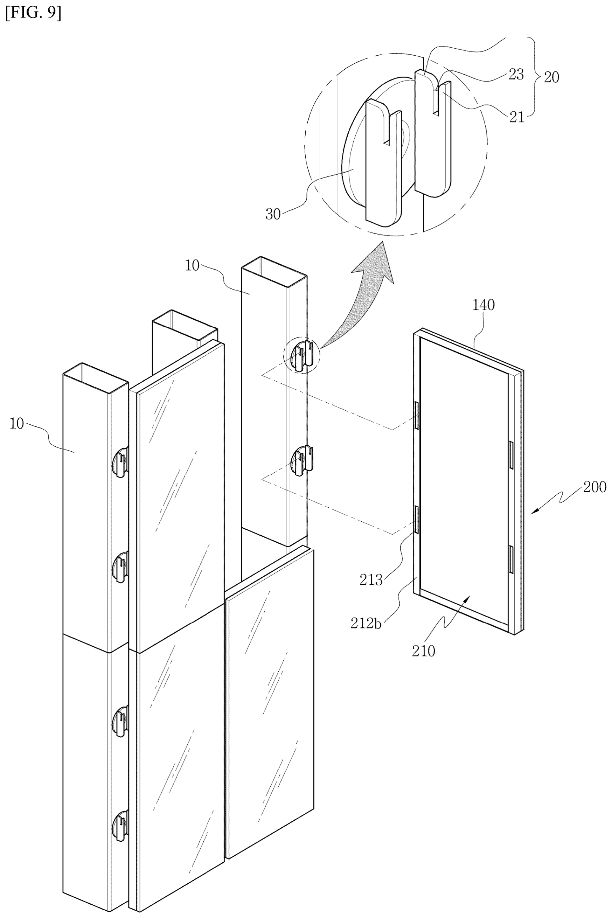

Referring to FIG. 9, the BIPV system according to the second embodiment includes the frame-integrated photovoltaic module 200 having a G-to-S structure according to the second embodiment and a structure 10.

The structure 10 provides a space in which the photovoltaic module 200 is fixed, and may be provided on one side of a building, for example, on an exterior wall or a roof of a building.

In the BIPV system according to the first embodiment, the structure 10 has a lattice pattern by a combination of the vertical bars 11 and the horizontal bars 12, whereas in the BIPV system according to the second embodiment, a lattice-pattern structure is not required. As an embodiment, the structure 10 may be configured with a plurality of vertical bars spaced and arranged at predetermined intervals, or may be configured with a plurality of horizontal bars spaced and arranged at predetermined intervals, and because a lattice-pattern structure is not required, the installation cost of the BIPV system can be reduced. Of course, the structure 10 may also be configured in a lattice pattern as in the first embodiment.

A module fixing bracket 20 is provided on one surface of the structure 10. The module-fixing bracket 20 is coupled to the bracket mounting groove 213 provided in the horizontal member 212b of the planar frame 210, the module-fixing bracket 20 may be divided into a first bracket 21 and a second bracket 22, and a recessed seat 23 is provided between the first bracket 21 and the second bracket 22.

The first bracket 21 of the module-fixing bracket 20 is inserted into the bracket mounting groove 213, and the horizontal member 212b above the bracket mounting groove 213 is fitted in the seat 23 between the first bracket 21 and the second bracket 22. In this manner, the photovoltaic module is fastened and fixed to the structure 10.

Further, two module-fixing brackets 20 may be provided as a pair and spaced apart from each other, and in this case, two adjacent photovoltaic modules 200 can be fixed through the respective module-fixing brackets 20.

Meanwhile, the module fixing bracket 20 may be provided directly on one surface of the structure 10 as described above, or may be provided on one surface of the structure 10 in combination with a bracket mounting member 30. In the latter case, the bracket mounting member 30 is fixed to one surface of the structure 10, and the module-fixing bracket 20 is provided on one side of the bracket mounting member 30.

When the BIPV system according to the second embodiment of the present disclosure described above is compared with the prior art, in the prior art, as shown in FIG. 1C, hanging brackets 2a and 2b must be provided not only on a structure but also on one side of the photovoltaic module, whereas in the present disclosure, because a module fixing bracket 21 is inserted into the bracket mounting groove 213 provided at the horizontal member 212b of the planar frame 210, hanging brackets as in the prior art do not need to be mounted on the photovoltaic module.

Next, the BIPV system according to the third embodiment is described.

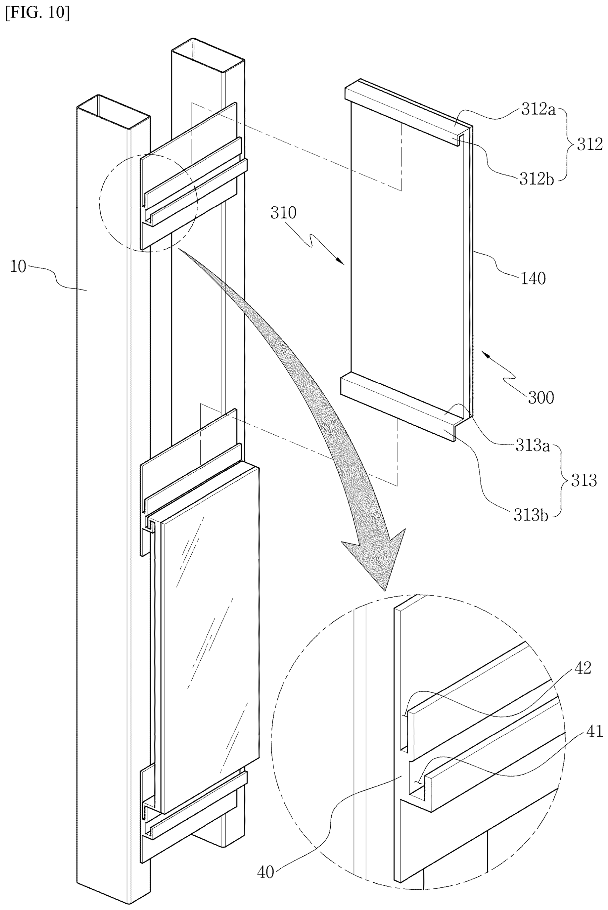

Referring to FIG. 10, the BIPV system according to the third embodiment includes the frame-integrated photovoltaic module 300 having a G-to-S structure according to the third embodiment and a structure 10.

The structure 10 provides a space in which the photovoltaic module 300 is fixed, and may be provided on one side of a building, for example, on an exterior wall or a roof of a building. The structure 10 according to the third embodiment, like the second embodiment, does not require a lattice-pattern structure, and as an embodiment, the structure 10 may be configured with a plurality of vertical bars spaced and arranged at predetermined intervals, or may be configured with a plurality of horizontal bars spaced and arranged at predetermined intervals.

A module fixing bracket 40 is provided on one surface of the structure 10. The module fixing bracket 40 includes a first seat 41 and a second seat 42. The first seat 41 provides a space in which the horizontal member 312b of the upper module fixing portion 312 of the planar frame 310 is seated, and the second seat 42 provides a space in which the horizontal member 313b of the lower module fixing portion 313 of the planar frame 310 is seated.

The module fixing brackets 40 are spaced apart and repeatedly arranged along the vertical direction of the structure 10. By way of example in which a first module fixing bracket 40 and a second module fixing bracket 40 spaced apart vertically are provided on the structure 10, the horizontal member 312b of the upper module fixing portion 312 is seated in the first seat 41 of the first module fixing bracket 40 positioned at the upper side, and the horizontal member 313b of the lower module fixing portion 313 is seated in the second seat 42 of the second module fixing bracket 40 positioned at the lower side. In this manner, a plurality of photovoltaic modules can be fixed to the structure 10 using a plurality of module fixing brackets 40.

In the BIPV system according to the third embodiment as well, the horizontal members 312b and 313b of the planar frame 310 are directly coupled to the module fixing brackets 40 provided on the structure 10, so that a hanger-type bracket 2a, such as that shown in FIG. 1C of the prior art, does not need to be mounted on the photovoltaic module.

The frame-integrated photovoltaic module having a G-to-S structure according to an embodiment of the present disclosure and the BIPV system using the frame-integrated photovoltaic module were described above. Hereinafter, a method for manufacturing the frame-integrated photovoltaic module having a G-to-S structure according to an embodiment of the present disclosure is described.

The method for manufacturing the frame-integrated photovoltaic module having a G-to-S structure according to an embodiment of the present disclosure is characterized in that the frame-integrated photovoltaic module having a G-to-S structure can be manufactured through a single laminating process.

As described above, the frame-integrated photovoltaic module having a G-to-S structure according to an embodiment of the present disclosure has a structure in which the photovoltaic module and the frame are integrated because the planar frame performs both the role of the rear light-transmitting glass of the G-to-G structure (or the back sheet of the G-to-B structure) and the role of a rectangular frame that is mounted on a photovoltaic module having a G-to-G (or G-to-B) structure.

The fact that the frame-integrated photovoltaic module having a G-to-S structure, in which the photovoltaic module and the frame are integrated, can be manufactured through a single laminating process means that the process of coupling a photovoltaic module and a frame is omitted.

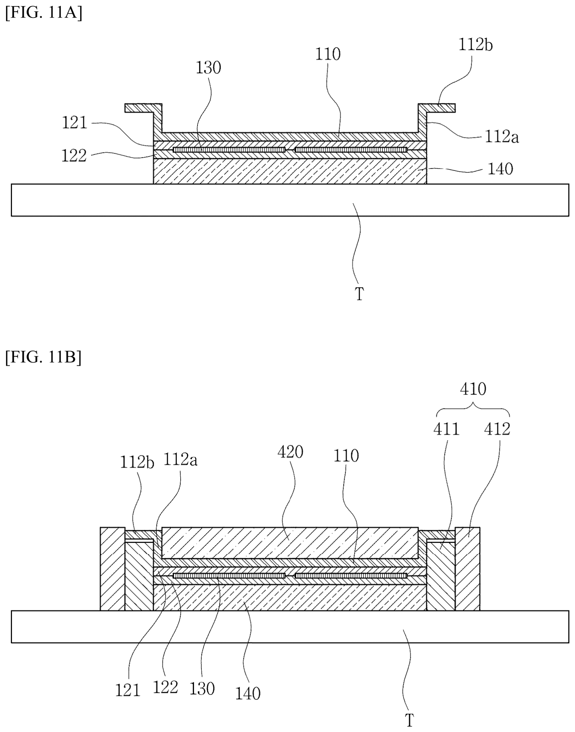

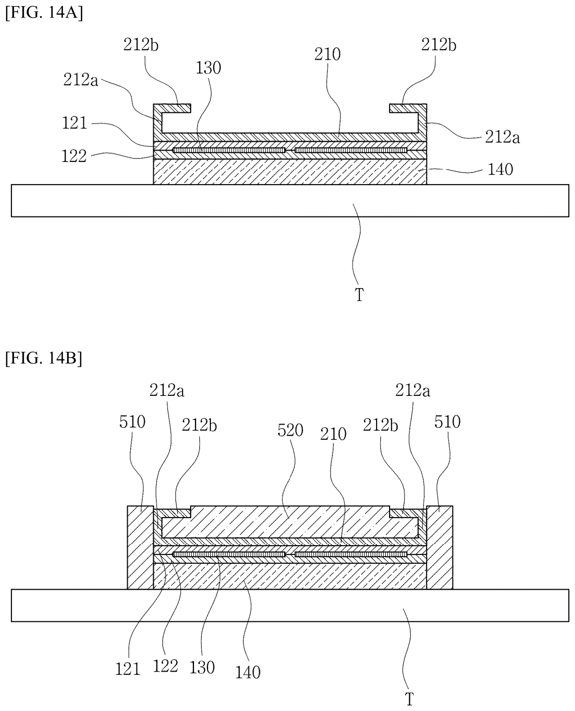

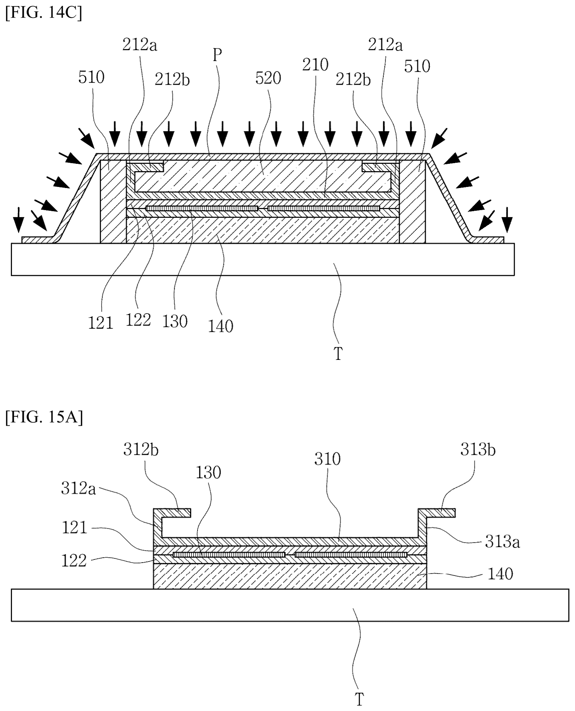

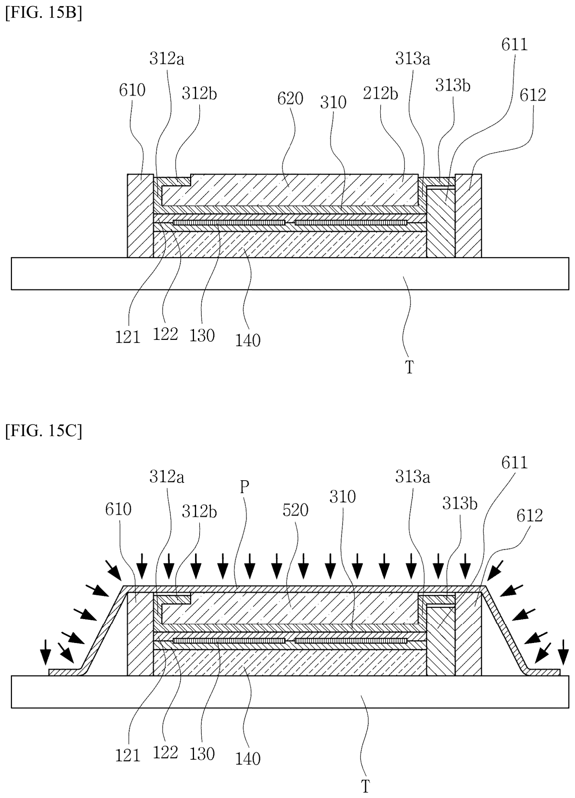

To implement this, as shown in FIG. 11A, a laminate object is seated onto a heating plate T of a vacuum laminating apparatus. FIGS. 11A to 11C are reference views for illustrating a method for manufacturing the frame-integrated photovoltaic module having a G-to-S structure to which the planar frame of the first embodiment is applied. The methods for manufacturing the frame-integrated photovoltaic modules having a G-to-S structure to which the planar frames of the second and third embodiments are applied are described with reference to FIGS. 14A to 14C and FIGS. 15A to 15C, respectively.

The laminate object refers to a structure in which the upper encapsulant 122, the photovoltaic cell 130, the lower encapsulant 121, and the planar frame 110 are sequentially stacked on the front light-transmitting glass 140, or a structure in which the encapsulant 123, the photovoltaic cell 130, the encapsulant 123, the insulating film 150, the encapsulant 123, and the planar frame 110 are sequentially stacked on the front light-transmitting glass 140. In this configuration, the front light-transmitting glass 140 is positioned on the upper surface of the heating plate T, and the planar frame 110 is seated to face a pressing pad P of the vacuum laminating apparatus. Such a seating structure may be regarded as a form in which the frame-integrated photovoltaic module having a G-to-S structure is turned upside down.

The reason for positioning the front light-transmitting glass 140 at the lower side and positioning the planar frame 110 at the upper side during laminating is for transferring uniform heat to the entire region of the photovoltaic module and for allowing uniform pressure to be applied to the entire region of the photovoltaic module when pressure is applied using the pressing pad P. On the contrary, if the planar frame 110 is positioned at the lower side and the front light-transmitting glass 140 is positioned at the upper side, only the horizontal member 112b of the module fixing portion 112 provided on the planar frame 110 comes into contact with the heating plate T, so uniform heat transfer is not achieved, and not only is uniform pressure not applied when pressure is applied by the pressing pad P, but there is also a possibility that the module fixing portion 112 may be damaged.

With a laminate object seated on the heating plate T, a bubble discharge guide member 410 is disposed on each of all sides of the laminate object, as shown in FIG. 11B. The bubble discharge guide member 410 is, in detail, divided into a first member 411 and a second member 412.

The first member 411 of the bubble discharge guide member 410 is disposed to be in contact with both the horizontal member 112b and the vertical member 112a of the module fixing portion 112, and the second member 412 is disposed adjacent to the horizontal member 112b of the module fixing portion 112. The height of the first member 411 is equal to or slightly lower than the height at which the lower surface of the horizontal member 112b is positioned, and it is preferable that the height of the second member 412 be designed to be slightly higher than the height at which the upper surface of the horizontal member 112b is positioned. The reason for making the height of the second member 412 higher than the height at which the upper surface of the horizontal member 112b is positioned is for preventing pressure of the pressing pad P from being applied to the horizontal member 112b of the module fixing portion 112 during laminating. The first member 411 and the second member 412 having such shapes extend along the longitudinal direction of each edge of the laminate object. In this configuration, the first member 411 and the second member 412 form an integral structure.

The bubble discharge guide members 410 as described above are disposed each of all sides of the laminate object, and a height compensation member 420 is provided in the interior space of the planar frame 110 (see FIG. 11B). As described above, the interior space of the planar frame 110 is a space defined by the plate portion 111 of the planar frame 110 and the vertical member 112a of the module fixing portion 112. It is preferable that the upper surface height of the height compensation member 420 provided in the interior space of the planar frame 110 be designed to be equal to the height of the second member 412 of the bubble discharge guide member 410. In addition, the bubble discharge guide member 410 is made of a material having higher thermal conductivity than glass to induce bubble movement using heat transfer. As an example, a metal may be used as the material constituting the bubble discharge guide member 410, but the present disclosure is not limited thereto.

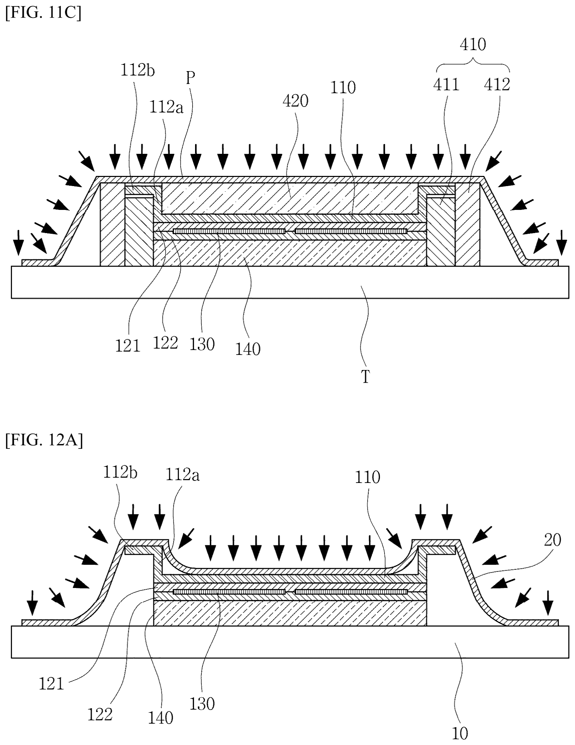

As described above, while the height compensation member 420 is provided in the interior space of the planar frame 110 and the bubble discharge guide members 410 are provided on each of all sides of the laminate object, as shown in FIG. 11C, laminating proceeds as the pressing pad P presses the laminate object. Through the configuration of the height compensation member 420 and the bubble discharge guide members 410, uniform pressure is applied to the laminate object, and bubbles generated in the encapsulant 120 during laminating can be easily discharged to the outside.

First, in terms of uniform pressure application, the interior space of the planar frame 110 is filled with the height compensation member 420, the first member 411 of the bubble discharge guide member 410 is provided below the horizontal member 112b of the module fixing portion 112, and the second member 412 is disposed side by side adjacent to the horizontal member 112b, whereby the pressure applied by the pressing pad P becomes uniform over the entire region of the laminating structure. In this state, because the first member 411 of the bubble discharge guide member 410 is provided below the horizontal member 112b of the module fixing portion 112, even if pressure from the pressing pad P is applied to the horizontal member 112b, it is possible to prevent stress from concentrating on the horizontal member 112b. Further, since the second member 412 of the bubble discharge guide member 410 and the height compensation member 420 have the same height and are designed to be higher than the upper surface height of the horizontal member 112b of the module fixing portion 112, it is possible to suppress stress from concentrating on the horizontal member 112b.

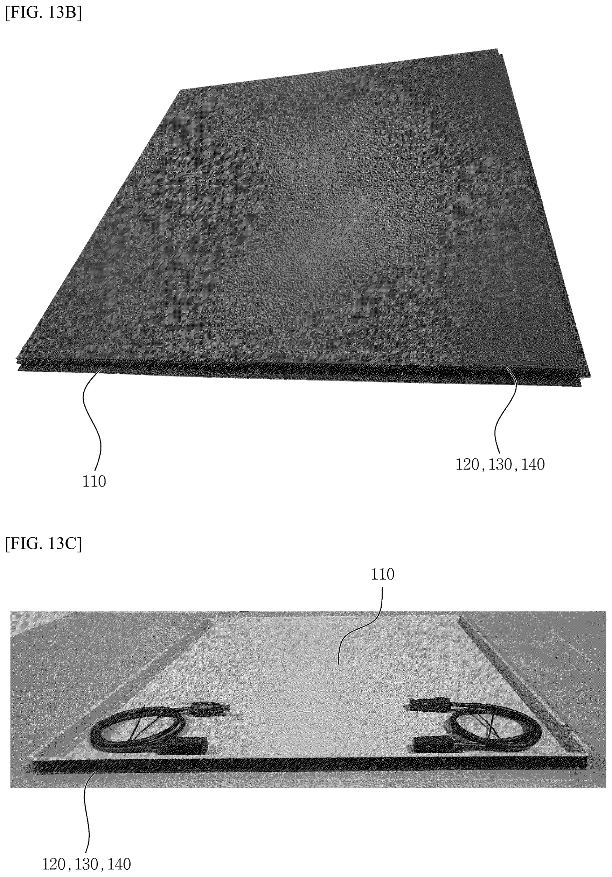

In terms of bubble discharge, during the laminating process, a certain amount of bubbles is generated in the gelation and crosslinking processes of the upper encapsulant 122 and the lower encapsulant 121, and since the encapsulant 120 is provided at a position in contact with the front light-transmitting glass 140, the thermal conductivity of the encapsulant 120 is inevitably directly affected by the thermal conductivity of the front light-transmitting glass 140. As described above, because the thermal conductivity of the bubble discharge guide member 410 is higher than that of the front light-transmitting glass 140, bubbles within the encapsulant 120 move from the front light-transmitting glass 140 toward the bubble discharge guide member 410, and in the course of this movement, the bubbles are discharged to the outside of the encapsulant 120. Through this principle, the residual bubbles in the encapsulant 120 during laminating of the photovoltaic module having a G-to-S structure can be minimized (see FIG. 13B). This bubble discharge mechanism operates effectively not only when EVA is applied as the encapsulant 120 but also when POE is used.

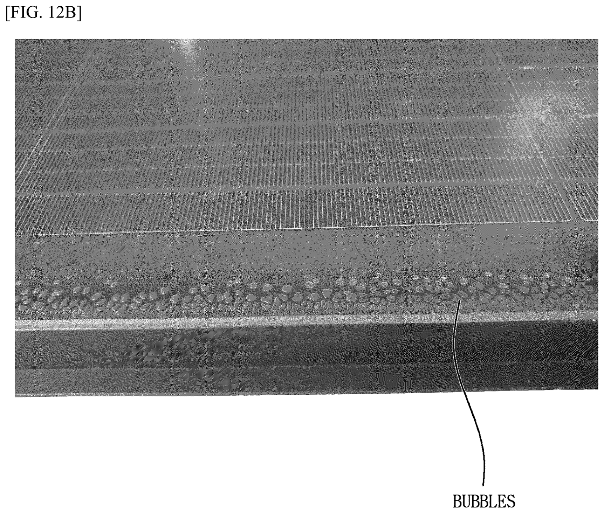

If laminating is performed without the height compensation member 420 and the bubble discharge guide member 410 disposed as shown in FIG. 12A, the pressure of the pressing pad P cannot be uniformly applied to the laminate object due to the protruding shape of the module fixing portion 112, and stress is concentrated on the module fixing portion 112, whereby many bubbles remain at the edges of the photovoltaic module after completion of laminating (see FIG. 12B)

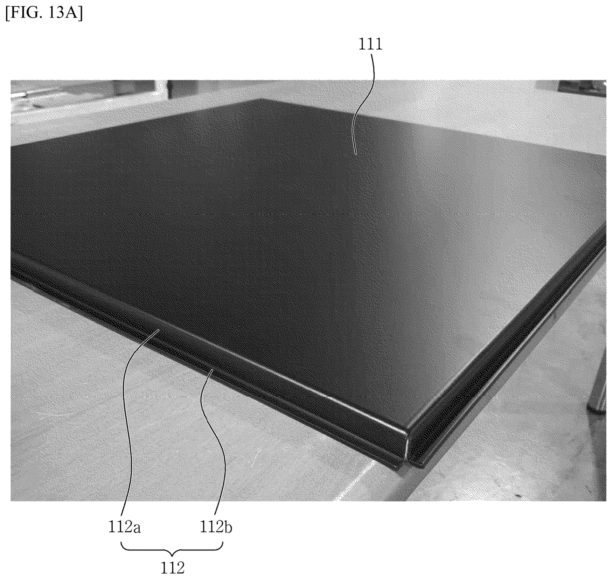

FIG. 13A is a photograph of a planar frame that is actually manufactured according to the first embodiment, FIG. 13B is a photograph after the frame-integrated photovoltaic module having a G-to-S structure, in which an encapsulant in which the photovoltaic cell is encapsulated and a front light-transmitting glass are sequentially stacked on the planar frame by a single laminating process, is manufactured according to the first embodiment, and FIG. 13C is a photograph of the rear surface of the frame-integrated photovoltaic module having a G-to-S structure according to the first embodiment shown in FIG. 13B.

Next, the methods for manufacturing the frame-integrated photovoltaic modules having a G-to-S structure to which the planar frames of the second embodiment and the third embodiment are applied are described.

The purposes of the manufacturing methods of the second embodiment and the third embodiment are substantially the same as those that the manufacturing method of the first embodiment seeks to achieve. As described above, the manufacturing method of the first embodiment manufactures a frame-integrated photovoltaic module having a G-to-S-structure through a single laminating process and the objective thereof is to transfer uniform heat and uniform pressure and to minimize residual bubbles during laminating, and the objectives of the manufacturing methods of the second embodiment and the third embodiment are also to achieve the same result.

However, because the shape of the planar frames according to the second embodiment and the third embodiment is different from the planar frame of the first embodiment, the shapes of the height compensation member and the bubble discharge guide member are designed differently.

First, the height compensation member 520 and the bubble discharge guide member 510 in the manufacturing method of the second embodiment are designed as follows (see FIGS. 14A to 14C).

The upper surface height of the height compensation member 520 is designed to be slightly higher than the upper surface height of the horizontal member 212b. However, in consideration of the fact that the horizontal members 212b of the module fixing portions 212 provided at both sides of the plate portion 211 have a shape of being bent toward the interior of the plate portion 211, the upper surface height of the height compensation member 520 provided below the horizontal member 212b must be designed to be equal to or lower than the lower surface height of the horizontal member 212b. Further, the bubble discharge guide members 510 provided at both sides of the plate portion 211 are designed in the form of the second member 412 of the bubble discharge guide member 410 applied to the manufacturing method of the first embodiment.

By applying the height compensation member 520 and the bubble discharge guide member 510 having such shapes, it is possible to apply uniform pressure over the entire front surface of the photovoltaic module during laminating, and it is also possible to easily discharge the bubbles in the encapsulant.

Next, the height compensation member 620 and the bubble discharge guide member 610 in the manufacturing method of the third embodiment are designed as follows (see FIGS. 15A to 15C).

The upper surface height of the height compensation member 620 is designed to be slightly higher than the upper surface heights of the horizontal members 312b and 313b. This is for preventing stress from being generated due to concentration of pressure on the horizontal members 312b and 313b by the pressing pad P, and in consideration of the fact that the horizontal member 312b of the upper module fixing portion 312 has a shape of being bent toward the interior of the plate portion 311, the upper surface height of the height compensation member 620 provided below the horizontal member 312b of the upper module fixing portion 312 must be designed to be equal to or lower than the lower surface height of the horizontal member 312b of the upper module fixing portion 312.

In the case of the bubble discharge guide member 610, it is designed in the same manner as the bubble discharge guide member 410 that is composed of the first member 411 and the second member 412 applied in the manufacturing method of the first embodiment. However, the bubble discharge guide member 610 provided on one side of the vertical member 312a of the upper module fixing portion 312 is configured only in the form of the second member 412.

By applying the height compensation member 620 and the bubble discharge guide member 610 having such shapes, it is possible to apply uniform pressure over the entire front surface of the photovoltaic module during laminating, and it is also possible to easily discharge the bubbles in the encapsulant.

A frame-integrated photovoltaic module having a G to S structure according to an embodiment of the present disclosure, a BIPV system using the frame-integrated photovoltaic module, and a method for manufacturing the frame-integrated photovoltaic module having a G to S structure were described above. Hereinafter, the present disclosure is described in more detail through experimental examples.

Experimental Example: Heat dissipation characteristic and power generation efficiency of photovoltaic module according to temperature variations

The heat dissipation characteristic and power generation efficiency according to temperature variations of the frame-integrated photovoltaic module having a G-to-S structure manufactured according to the first embodiment of the present disclosure (hereafter, referred to as "G-to-S") were analyzed. For comparison, the heat dissipation characteristic and power generation efficiency of a photovoltaic module having a G-to-G structure (hereafter, referred to as "G-toG") were also analyzed under the same conditions.

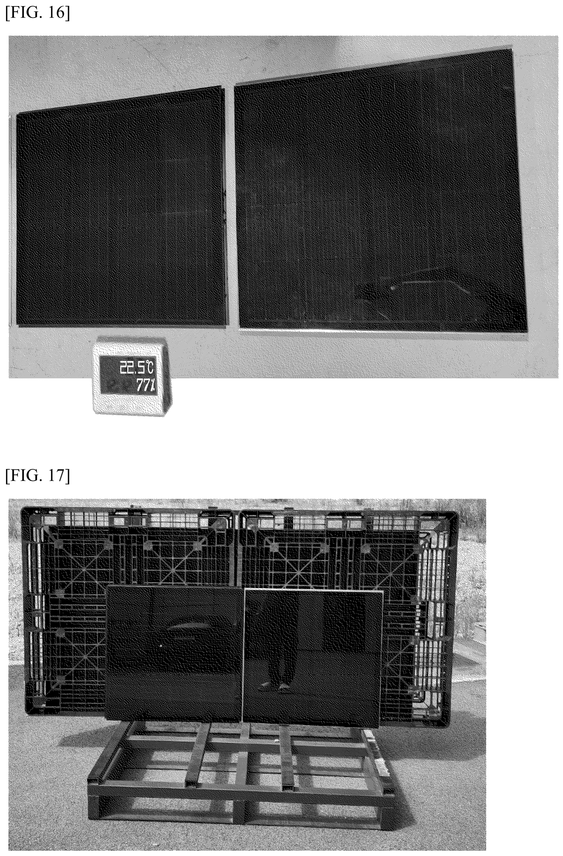

In both G-to-G and G-to-S, sixteen sheets of photovoltaic cells having power generation capacity of 5.69 W were mounted, and the photovoltaic modules were manufactured to have dimensions of 70 cm in both width and height. In FIG. 16, the left side shows the G-to-S, and the right side shows the G-to-G.

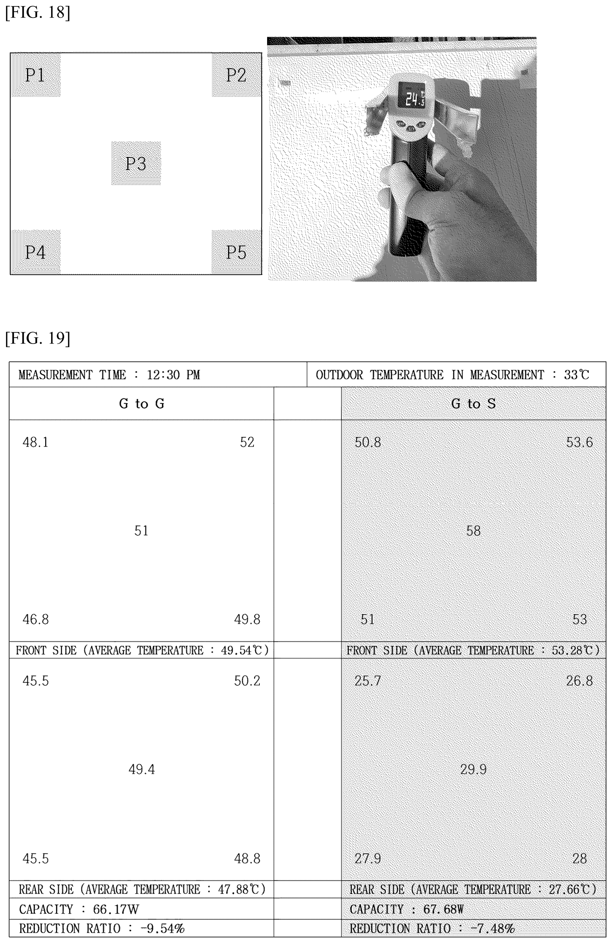

After storing the G-to-G and G-to-S at indoor room temperature (25°C) for one day, the power generation capacity was measured. Next, at around 9 a.m., each of the G-to-G and G-to-S was placed vertically on an outdoor pallet (see FIG. 17; in FIG. 17, G-to-S is shown on the left, and G-to-G is shown on the right), and the temperature and power generation capacity of the photovoltaic modules were measured at the time point after 3 hours and 30 minutes (around 12:30 p.m., outdoor temperature 33°C) and at the time point after 6 hours (around 3 p.m., outdoor temperature 29°C). For the temperature of the photovoltaic modules, in the case of the G-to-G, the temperatures of the front glass and rear glass were measured, and in the case of the G-to-S, the temperatures of the front glass and the planar frame were measured. Further, to compensate for temperature differences depending on the positions of the photovoltaic modules, the temperatures were measured at five points on the front side and five points on the rear side (see FIG. 18), and the averages of these values were regarded as the front-side temperature value and the rear-side temperature value. Finally, after the measurements of temperature and power generation capacity under the two outdoor conditions, each of the G-to-G and G-to-S was stored at indoor room temperature (25 °C) for one day, and the power generation capacity was then measured.

The experimental results are as follows.

As shown in Table 2 below, the initial power generation capacities of the G-to-G and the G-to-S at indoor room temperature (25°C) were both measured to be 73.15 W.

Under the outdoor temperature condition of 33°C, in the case of the G-to-G, the front-side temperature was measured to be 49.54°C and the rear-side temperature was measured to be 47.88°C, and the average of the front-side and rear-side temperatures was 48.71°C. In the case of the G-to-S, the front-side temperature (front glass side) was measured to be 53.28°C and the rear-side temperature (planar frame side) was measured to be 27.66°C, and the average of the front-side and rear-side temperatures was 40.47°C (see FIG. 19).

From these results, it can be seen that, in the case of the G-to-G, the difference between the front-side temperature and the rear-side temperature is not great, whereas in the case of the G-to-S, the rear-side temperature (27.66°C) is significantly lower compared to the front-side temperature (53.28°C). This is a result indicating that the heat dissipation characteristic of the planar frame applied to the G-to-S is very excellent, and due to this, whereas the average temperature of the G-to-G is 48.71°C, the average temperature of the G-to-S is only 40.47°C. For reference, the average temperature of the G-to-G and the average temperature of the G-to-S can be estimated as the temperature of the photovoltaic cells surrounded by the encapsulant.

As described in Non-Patent Literature 3, silicon-based photovoltaic cells experience a phenomenon in which the voltage decreases by a certain amount as temperature increases. Accordingly, since the average temperature (40.47°C) of the G-to-S is significantly lower than the average temperature (48.71°C) of the G-to-G, it can be expected that the reduction in power generation efficiency due to temperature rise is suppressed in the G-to-S relative to the G-to-G, and the experimental results are consistent with this.

The power generation capacity of the G-to-S at the average temperature of 40.47°C was measured to be 67.68 W, and the power generation capacity of the G-to-G at the average temperature of 48.71°C was measured to be 66.17 W. Compared with the initial power generation capacity of 73.15 W, the power generation capacity of the G-to-S decreased by -7.48%, whereas the power generation capacity of the G-to-G decreased by -9.54%.

These results are consistent with Non-Patent Literature 3 and can be regarded as demonstrating that the planar frame applied to the G-to-S exhibits an excellent heat dissipation characteristic and that the excellent heat dissipation characteristic can suppress the reduction in power generation efficiency of photovoltaic modules under a high-temperature environment.

Although the 2.06% (9.54% - 7.48%) difference in power generation capacity between the G-to-S and G-to-G may appear small, the difference should be considered significant in view of the daily accumulated power generation of each photovoltaic module and the fact that photovoltaic modules are installed in large numbers.

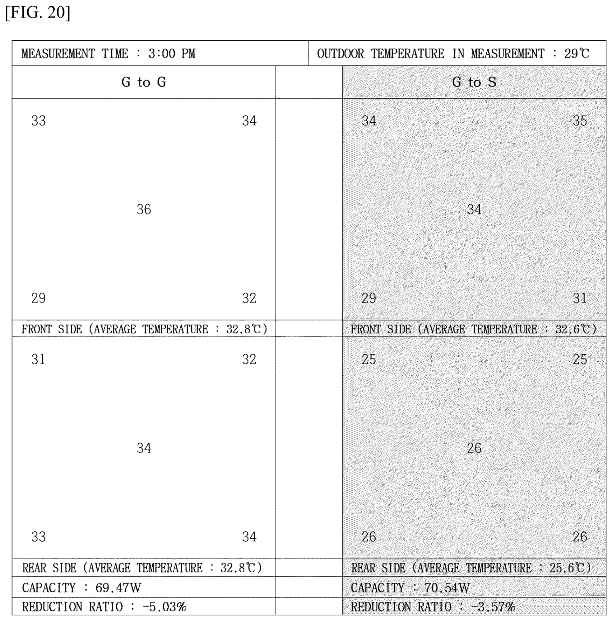

Next, at the time point when five hours had elapsed after outdoor exposure (with outdoor temperature of 29°C), in the case of the G-to-G, the temperature on the front side was measured to be 32.8°C, the temperature on the rear side was measured to be 32.8°C, and the average of the front-side and rear-side temperatures was 32.8°C. In the case of G-to-S, the front-side temperature (front glass side) was measured to be 32.6°C and the rear-side temperature (planar frame side) was measured to be 25.6°C, and the average of the front side and rear side temperatures was 29.1 (see FIG. 20).

The results measured at this outdoor temperature of 29°C exhibit the same tendency as the results measured at the outdoor temperature of 33°°C. That is, in the case of the G-to-G, there is almost no difference between the front-side temperature and the rear-side temperature, whereas in the case of the G-to-S, the rear-side temperature (25.66°C) is significantly lower than the front-side temperature (32.6°C). However, because the outdoor temperature decreased from 33°C to 29°C and a substantial outdoor exposure time had elapsed, both the G-to-G and the G-to-S exhibited reduced temperatures. Nevertheless, it can be confirmed that the heat dissipation characteristic of the G-to-S remains superior.

At an outdoor temperature of 29°C, the power generation capacity of the G-to-S at the average temperature of 29.1°C was measured to be 70.54 W, and the power generation capacity of the G-to-G at the average temperature of 32.8°C was measured to be 69.47 W. It can be confirmed that, as the outdoor temperature decreased relative to the case of the outdoor temperature of 33°C, the power generation capacities of both the G-to-S and the G-to-G increased.

These power generation capacity values indicate that, compared with the initial power generation capacity of 73.15 W, the power generation capacity of the G-to-S decreased by -3.57%, whereas the power generation capacity of the G-toG decreased by -5.03%. Further, the difference in power generation capacity between the G-to-S and the G-to-G is 1.46% (5.03% - 3.57%).

Although the 1.46% difference in power generation capacity is lower than the 2.06% difference at the outdoor temperature of 33°C, it can still be regarded as a substantial difference in power generation capacity in view of the daily accumulated power generation of each photovoltaic module and the fact that a plurality of photovoltaic modules are installed.

After the temperature and power generation capacity measurements under the two outdoor conditions, the G-to-G and the G-to-S were each stored at indoor room temperature (25°C) for one day, and the power generation capacity was then measured. As a result, it was confirmed that both the G-to-G (73.24 W) and the G-to-S (73.28 W) exhibited their initial power generation efficiency.

**[Table 2]**

| Item | | G to G | G to S | Remark |
|---|---|---|---|---|
| Indoor (25°C) | Measured power generation capacity | 73.15W | 73.15W | |
| Outdoor (33°C) (12:30 p.m.) | Front-side temperature | 49.54°C | 53.28°C | |
| | Rear-side temperature | 47.88°C | 27.66°C | |
| | Average temperature between front and rear | 48.71°C | 40.47°C | |
| | Measured power generation capacity | 66.17W | 67.68W | |
| | Reduction ratio | -9.54% | -7.48% | G to S - 2.06% superior |
| Outdoor (29°C) (3:00 p.m.) | Front-side temperature | 32.8°C | 32.6°C | |
| | Rear-side temperature | 32.8°C | 25.6°C | |
| | Average temperature between front and rear | 32.8°C | 29.1°C | |
| | Measured power generation capacity | 69.47W | 70.54W | |
| | Reduction ratio | -5.03% | -3.57% | G to S - 1.46% superior |
| Indoor (25°C) (after tests) | Measured power generation capacity | 73.24W | 73.28W | |

### [Reference Signs List]

1: Photovoltaic module
2: Rectangular frame
3: Adhesive
4, 10: Structure
11: Vertical bar
12: Horizontal bar
20, 40: Module fixing bracket
21: First bracket
22: Second bracket
23: Seat
30: Bracket mounting member
41: First seat
42: Second seat
110, 210, 310: Planar frame
111: Plate portion
112: Module fixing portion
112a, 212a, 312a, 313a: Vertical member
112b, 212b, 312b, 313b: Horizontal member
120, 123: Encapsulant
121: Lower encapsulant
122: Upper encapsulant
130: Photovoltaic cell
140: Front light-transmitting glass
150: Insulating film
213: Bracket mounting groove
410, 510, 610: Bubble discharge guide member
420, 520, 620: Height compensation member
411: First member
412: Second member
T: Heating plate
P: Pressing pad
100: Frame-integrated photovoltaic module having G-to-S structure according to first embodiment
200: Frame-integrated photovoltaic module having G-to-S structure according to first embodiment
300: Frame-integrated photovoltaic module having G-to-S structure according to first embodiment

## Claims

1. A frame-integrated photovoltaic module having a G-to-S structure, comprising:
a planar frame that provides a mounting space for an encapsulant, a photovoltaic cell, and a front light-transmitting glass, and that serves as a mechanical medium enabling mounting to a specific structure;
an encapsulant in which the photovoltaic cell provided on the planar frame is encapsulated; and
the front light-transmitting glass provided on the encapsulant in which the photovoltaic cell is encapsulated,
wherein a structure in which the encapsulant, in which the photovoltaic cell is encapsulated, and the front light-transmitting glass are sequentially stacked on the planar frame is formed through a single laminating process.

2. The frame-integrated photovoltaic module of claim 1, wherein the planar frame is made of a metal material having excellent thermal conductivity, thereby performing a role of a heat dissipation plate that dissipates heat in the photovoltaic module to the outside.

3. The frame-integrated photovoltaic module of claim 1, wherein the planar frame includes:
a plate portion that provides a mounting space for the encapsulant, the photovoltaic cell, and the front light-transmitting glass; and
a module fixing portion provided on at least one edge of the plate portion and performing a role of the mechanical medium enabling mounting to a specific structure.

4. The frame-integrated photovoltaic module of claim 3, wherein the module fixing portion includes a vertical member and a horizontal member, and
the vertical member is provided on at least one edge of the plate portion to be perpendicular to the plate portion, and the horizontal member is provided to be perpendicular to an end of the vertical member and disposed toward the outside of the plate portion.

5. The frame-integrated photovoltaic module of claim 1, wherein the planar frame includes:
a plate portion that provides a mounting space for the encapsulant, the photovoltaic cell, and the front light-transmitting glass; and
a module fixing portion provided on both sides of the plate portion and performing a role of the mechanical medium enabling mounting to a specific structure,
the module fixing portion includes a vertical member and a horizontal member, and
the vertical member is provided on both sides of the plate portion to be perpendicular to the plate portion, and the horizontal member is provided to be perpendicular to an end of the vertical member and disposed toward the inside of the plate portion.

6. The frame-integrated photovoltaic module of claim 5, wherein the horizontal member has a bracket mounting groove formed by boring the horizontal member by a predetermined area, and
when the photovoltaic module is mounted on a specific structure, the bracket mounting groove is coupled in a hanger-type to a module fixing bracket fixed to the structure.

7. The frame-integrated photovoltaic module of claim 1, wherein the planar frame includes:
a plate portion that provides a mounting space for the encapsulant, the photovoltaic cell, and the front light-transmitting glass; and
an upper module fixing portion and a lower module fixing portion respectively provided on an upper edge and a lower edge of the plate portion,
the upper module fixing portion includes:
a vertical member provided on the upper edge of the plate portion to be perpendicular to the plate portion, and a horizontal member provided to be perpendicular to an end of the vertical member and disposed toward the inside of the plate portion, and
the lower module fixing portion includes:
a vertical member provided on the lower edge of the plate portion to be perpendicular to the plate portion, and a horizontal member provided to be perpendicular to an end of the vertical member and disposed toward the outside of the plate portion.

8. The frame-integrated photovoltaic module of claim 7, wherein when the photovoltaic module is mounted on a specific structure, the horizontal member of the upper module fixing portion and the horizontal member of the lower module fixing portion are coupled in a hanger-type to module fixing brackets fixed to the structure.

9. The frame-integrated photovoltaic module of any one of claims 4 to 8, wherein an internal space is defined on a rear side of the planar frame by the plate portion and the vertical member, and
a junction box and wirings are accommodated in the internal space of the planar frame.

10. The frame-integrated photovoltaic module of claim 1, wherein the encapsulant is made of polyolefin elastomer (POE) or ethylene vinyl acetate copolymer (EVA).

11. The frame-integrated photovoltaic module of claim 1, wherein an insulating steel plate is used as the planar frame or insulating coating is applied to the planar frame for electrical insulation from the photovoltaic cell.

12. The frame-integrated photovoltaic module of claim 1, wherein an insulating film having electrical insulation property is provided between the planar frame and the photovoltaic cell.

13. A BIPV system using a frame-integrated photovoltaic module having a G-to-S structure, the BIPV system comprising:
a frame-integrated photovoltaic module having a G-to-S structure; and
a structure providing a mounting space for the frame-integrated photovoltaic module having a G-to-S structure,
wherein the structure has a configuration in which a plurality of vertical bars and horizontal bars are arranged in a lattice pattern and a rectangular unit mounting space is defined by the plurality of vertical bars and horizontal bars;
the frame-integrated photovoltaic module having a G-to-S structure is the frame-integrated photovoltaic module having a G-to-S structure of claim 4; and
bolts are fastened to the vertical bar or the horizontal bar through the horizontal member with the plate portion of the planar frame disposed in the unit mounting space and the horizontal member of the planar frame supported on surfaces of the vertical bars and horizontal bars around the unit mounting space.

14. A BIPV system using a frame-integrated photovoltaic module having a G-to-S structure, the BIPV system comprising:
a frame-integrated photovoltaic module having a G-to-S structure;
a structure providing a mounting space for the frame-integrated photovoltaic module having a G-to-S structure; and
a module fixing bracket provided on one surface of the structure,
wherein the frame-integrated photovoltaic module having a G-to-S structure is the frame-integrated photovoltaic module having a G-to-S structure of claim 6;
wherein the module fixing bracket is divided into a first bracket and a second bracket, and a recessed seat is provided between the first bracket and the second bracket; and
the first bracket of the module fixing bracket is inserted in a bracket mounting groove, and the horizontal member above the bracket mounting groove is fitted in the seat between the first bracket and the second bracket.

15. The BIPV system of claim 14, wherein two module fixing brackets are provided as a pair and spaced apart from each other, and two adjacent frame-integrated photovoltaic modules having a G-to-S structure are fixed to the module fixing brackets, respectively.

16. A BIPV system using a frame-integrated photovoltaic module having a G-to-S structure, the BIPV system comprising:
a frame-integrated photovoltaic module having a G-to-S structure;
a structure providing a mounting space for the frame-integrated photovoltaic module having a G-to-S structure; and
a plurality of module fixing brackets spaced apart and repeatedly arranged on one surface of the structure along a vertical direction of the structure,
wherein the frame-integrated photovoltaic module having a G-to-S structure is the frame-integrated photovoltaic module having a G-to-S structure of claim 7;
the module fixing brackets include a first seat that provides a space in which the horizontal member of the upper module fixing portion is seated and a second seat that provides a space in which the horizontal member of the lower module fixing portion is seated; and
when a first module fixing bracket and a second module fixing bracket spaced apart vertically are provided on the structure, the horizontal member of the upper module fixing portion is seated in a first seat of the first module fixing bracket positioned at an upper side, and the horizontal member of the lower module fixing portion is seated in a second seat of the second module fixing bracket positioned at a lower side.

17. A method for manufacturing a frame-integrated photovoltaic module having a G-to-S structure, the method comprising:
seating a laminate object on a heating plate of a laminating apparatus;
disposing a bubble discharge guide member at a side of the laminate object and disposing a height compensation member in an interior space of a planar frame positioned at an uppermost position of the laminate object; and
performing laminating by pressing the laminate object using a pressing pad,
wherein the laminate object is a structure including a photovoltaic cell and an encapsulant between a front light-transmitting glass and the planar frame.

18. The method of claim 17, wherein the laminate object is a structure in which an upper encapsulant, a photovoltaic cell, a lower encapsulant, and a planar frame are sequentially stacked on a front light-transmitting glass.

19. The method of claim 17, wherein the laminate object is a structure in which an encapsulant, an insulating film, an encapsulant, a photovoltaic cell, an encapsulant, and a planar frame are sequentially stacked on a front light-transmitting glass.

20. The method of claim 17, wherein the planar frame includes a plate portion providing a mounting space for an encapsulant, a photovoltaic cell, and a front light-transmitting glass, and a module fixing portion provided on each edge of the plate portion and performing a role of a mechanical medium enabling mounting to a specific structure;
the module fixing portion includes a vertical member and a horizontal member, the vertical member is provided on each edge of the plate portion to be perpendicular to the plate portion, and the horizontal member is provided to be perpendicular to one end of the vertical member and disposed toward the outside of the plate portion;
an internal space is defined on a rear side of the planar frame by the plate portion and the vertical member, and
an upper surface height of the height compensation member is higher than an upper surface height of the horizontal member.

21. The method of claim 20, wherein a bubble discharge guide member is divided into a first member and a second member;
the first member of the bubble discharge guide member is disposed in contact with both the horizontal member and the vertical member of the module fixing portion, and the second member is disposed adjacent to the horizontal member of the module fixing portion; and
a height of the first member corresponds to a height at which a lower surface of the horizontal member is positioned, and a height of the second member is higher than a height at which an upper surface of the horizontal member is positioned.

22. The method of claim 17, wherein the planar frame includes a plate portion providing a mounting space for an encapsulant, a photovoltaic cell, and a front light-transmitting glass, and a module fixing portion provided on both sides of the plate portion and performing a role of a mechanical medium enabling mounting to a specific structure;
the module fixing portion includes a vertical member and a horizontal member, and
the vertical member is provided on both sides of the plate portion to be perpendicular to the plate portion, and the horizontal member is provided to be perpendicular to one end of the vertical member and disposed toward the inside of the plate portion;
an internal space is defined on a rear side of the planar frame by the plate portion and the vertical member; and
an uppermost surface height of the height compensation member and an uppermost surface height of the bubble discharge guide member are higher than a height of the horizontal member.

23. The method of claim 17, wherein the planar frame includes a plate portion providing a mounting space for an encapsulant, a photovoltaic cell, and a front light-transmitting glass, and an upper module fixing portion and a lower module fixing portion respectively provided on an upper edge and a lower edge of the plate portion;
the upper module fixing portion includes a vertical member provided on the upper edge of the plate portion to be perpendicular to the plate portion, and a horizontal member provided to be perpendicular to an end of the vertical member and disposed toward the inside of the plate portion;
the lower module fixing portion includes a vertical member provided on the lower edge of the plate portion to be perpendicular to the plate portion, and a horizontal member provided to be perpendicular to an end of the vertical member and disposed toward the outside of the plate portion;
an internal space is defined on a rear side of the planar frame by the plate portion and the vertical member; and
an uppermost surface height of the height compensation member and an uppermost surface height of the bubble discharge guide member are higher than a height of the horizontal member.

24. The method of claim 17, wherein,
the bubble discharge guide member is made of a material that is higher in thermal conductivity than the front light-transmitting glass; and
during laminating, bubbles in the encapsulant move from the front light-transmitting glass toward the bubble discharge guide member and are discharged to the outside of the encapsulant.

25. The method of claim 17, wherein,
the encapsulant is made of polyolefin elastomer (POE) or ethylene vinyl acetate copolymer (EVA).
